(19) Europäisches Patentamt
European Patent Office
Office européen des brevets

(11) **EP 4 502 000 A1**

(12) **EUROPEAN PATENT APPLICATION**
published in accordance with Art. 153(4) EPC

(43) Date of publication:
**05.02.2025 Bulletin 2025/06**

(21) Application number: **23779060.5**

(22) Date of filing: **22.02.2023**

(51) International Patent Classification (IPC):
***C08G 59/00*** (2006.01) ***B32B 15/092*** (2006.01)
***B32B 15/20*** (2006.01) ***B32B 27/20*** (2006.01)
***B32B 27/38*** (2006.01) ***C08K 3/38*** (2006.01)
***C08L 63/00*** (2006.01) ***H01L 23/29*** (2006.01)
***H01L 23/31*** (2006.01) ***H01L 23/36*** (2006.01)
***H01L 23/373*** (2006.01)

(52) Cooperative Patent Classification (CPC):
**B32B 15/092; B32B 15/20; B32B 27/20; B32B 27/38; C08G 59/00; C08K 3/38; C08L 63/00; H01L 23/29; H01L 23/31; H01L 23/36; H01L 23/373**

(86) International application number:
**PCT/JP2023/006385**

(87) International publication number:
**WO 2023/189030 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.03.2022 JP 2022051361**

(71) Applicant: **Mitsubishi Chemical Corporation**
**Tokyo 100-8251 (JP)**

(72) Inventors:
- **KIMURA Akinori**
  **Tokyo 100-8251 (JP)**
- **TANAKA Toshiyuki**
  **Tokyo 100-8251 (JP)**

(74) Representative: **Hoffmann Eitle**
**Patent- und Rechtsanwälte PartmbB**
**Arabellastraße 30**
**81925 München (DE)**

# (54) THERMOSETTING RESIN COMPOSITION, RESIN CURED PRODUCT AND COMPOSITE MOLDED BODY

(57) A thermosetting resin composition that is capable of suppressing the occurrence of gaps that form between an adherend and a sheet even when the sheet is closely adhered by pressing against an adherend having a roughened surface with a low pressing force. The thermosetting resin composition includes an epoxy resin as a main component resin and boron nitride agglomerated particles as an inorganic filler. A proportion of the boron nitride agglomerated particles in the resin composition is 40% by volume or more and 50% by volume or less, and a proportion of the inorganic filler other than the boron nitride agglomerated particles in the resin composition is 7% by volume or less.

## Description

### Technical Field

The present invention relates to a thermosetting resin composition capable of forming a thermally conductive resin sheet as a sheet-like cured product having thermal conductivity and insulation properties, and in particular a thermosetting resin composition containing boron nitride agglomerated particles, as well as a resin cured product and composite molded article using the composition.

### Background Art

In recent years, power semiconductor devices used in various fields such as railroads, automobiles, industrial applications, and general home appliances have been evolving from conventional Si power semiconductors into power semiconductors that use SiC, AlN, GaN, and the like in order to reduce size, reduce costs, and improve efficiency.

A power semiconductor device is generally used as a power semiconductor module that packages a plurality of semiconductor devices arranged on a common heat sink.

Various issues have been pointed out in relation to the practical application of such power semiconductor devices, one of which is the problem of heat generation from the device.

Power semiconductor devices can achieve high output and high density by operating at high temperatures, and there are concerns that heat generation and the like associated with device switching may reduce the reliability of the power semiconductor device.

Further, heat generation due to the increased density of integrated circuits has become a major issue in the electrical and electronic fields, and how to dissipate heat has become an urgent issue. For example, to ensure stable operation of the semiconductor device used to control the central processing unit in a personal computer, the motor in an electric vehicle, and the like, a heat sink, heat dissipation fins, or the like is essential for heat dissipation, and the member that joins the semiconductor device with the heat sink or the like needs to have both thermal conductivity and insulation properties.

Ceramic substrates with high thermal conductivity, such as alumina substrates and aluminum nitride substrates, have conventionally been used as a member that can achieve both thermal conductivity and insulation properties. However, ceramic substrates have suffered from issues such as being easily broken when subjected to a shock, difficult to form into a thin film, and difficult to miniaturize.

Therefore, a thermally conductive resin sheet has been proposed as a sheet-like cured product of a thermosetting resin composition containing a thermosetting resin such as an epoxy resin and a conductive inorganic filler.

Among them, boron nitride (sometimes abbreviated as "BN") agglomerated particles as a conductive filler are a ceramic having insulation properties, and are a material that in recent years has been drawing particular focus in the electrical and electronic material fields because of their characteristics of excellent thermal conductivity, solid lubricity, chemical stability, and heat resistance.

However, boron nitride agglomerated particles easily absorb a resin due to the structure of the particles, and thus when only boron nitride agglomerated particles are used as a conductive filler, it is difficult to further increase thermal conductivity. Therefore, it is usual to use boron nitride agglomerated particles in combination with another conductive inorganic filler.

For example, regarding thermally conductive resin sheets that use boron nitride agglomerated particles, Patent Literature 1 proposes a heat-dissipating resin sheet containing an epoxy resin having a Tg of 60°C or lower and boron nitride, wherein the boron nitride has a content of 30% by volume or more and 60% by volume or less. In actual fact, boron nitride agglomerated particles having a card-house structure and boron nitride particles having a non-card-house structure are used in combination as an inorganic filler (see Examples).

Patent Literature 2 proposes a heat-dissipating sheet that includes an agglomerated inorganic filler and a resin, in which when observed as a cross-section in the thickness direction of the heat-dissipating sheet, the agglomerated inorganic filler particles are in contact with each other and the outer edge of the particles, which is the contact interface between the agglomerate inorganic filler particles, are deformed and/or are destroyed during sheet molding, whereby the agglomerated inorganic filler particles come into contact with each other to form a straight portion. In actual fact, boron nitride agglomerated particles having a card-house structure and spherical alumina particles are used in combination as an inorganic filler (see Examples).

Citation List

Patent Literature

Patent Literature 1
Japanese Patent Laid-Open No. 2017-036415
Patent Literature 2
International Publication No. WO2019/189746

Summary of Invention

Technical Problem

In recent power semiconductor devices and the like, the surface of the adherend (e.g. copper plate) to which the thermally conductive resin sheet is bonded may be roughened and have an irregular structure for the purpose of achieving an anchoring effect to increase adhesion properties (such a surface is also referred to as a "roughened surface").

It has been found that when a conventional sheet in which boron nitride agglomerated particles are used, that is, a sheet containing a combination of boron nitride agglomerated particles and other conductive inorganic particles as described above, is laminated on an adherend having such a roughened surface, gaps occur between the sheet and the roughened surface of the adherend, resulting in a decrease in adhesion, which may result in a decrease in voltage resistance.

When joining the thermally conductive resin sheet and the adherend, there is a tendency to reduce the press pressure during joining from the perspectives of shortening the process and the pressure resistance of the parts, and thus issue of insufficient adhesion between the thermally conductive resin sheet and the adherend is expected to become even more important in the future. For example, when bonding a thermally conductive resin sheet to a composite member on which a semiconductor element or the like is mounted on a copper plate, there is a limit to the press pressure in terms of the pressure resistance of the composite member. At this time, unless a high pressure is applied, the flow of the resin and the deformation of the agglomerated filler become increasingly insufficient, and it becomes increasingly difficult to increase the adhesion properties with the roughened surface of the adherend.

Accordingly, it is an object of the present invention to provide a thermosetting resin composition containing boron nitride agglomerated particles for forming a thermally conductive resin sheet that, when closely adhering the thermally conductive resin sheet by pressing against an adherend having the above roughened surface, is capable of suppressing the occurrence of gaps that form between the adherend and the sheet even when the sheet is pressed with a low pressing force, specifically, an applied pressure of less than 70 $kgf/cm^2$.

Solution to Problem

The present inventors found that, in a thermosetting resin composition containing an inorganic filler and a thermosetting resin, which contains an epoxy resin as a main resin component and contains boron nitride agglomerated particles as the inorganic filler, the above-described problem could be solved by limiting the content proportion of an inorganic filler other than boron nitride agglomerated particles, and limiting the content of the boron nitride agglomerated particles to a predetermined range. That is, the present invention proposes a thermosetting resin composition, a resin cured product, and a composite molded body in modes having the following configurations.

[1] A first mode of the present invention is a thermosetting resin composition including an epoxy resin as a main component resin and boron nitride agglomerated particles as an inorganic filler, wherein a proportion of the boron nitride agglomerated particles in a total solid content of the thermosetting resin composition is 40% by volume or more and 50% by volume or less, and a proportion of the inorganic filler other than the boron nitride agglomerated particles in the total solid content of the thermosetting resin composition is 7% by volume or less.
[2] A second mode of the present invention is the thermosetting resin composition of the first mode, including at least one compound having imidazole as a curing catalyst.
[3] A third mode of the present invention is the thermosetting resin composition of the first or second mode, which has a thermal conductivity of 12 W/mK or more after thermosetting.
[4] A fourth mode of the present invention is the thermosetting resin composition of any one the first to third modes, including a polymer having a mass average molecular weight of 10,000 or more as the epoxy resin.
[5] A fifth mode of the present invention is the thermosetting resin composition of any one the first to fourth modes,

wherein the thermosetting resin composition includes, as the epoxy resin, a polyfunctional epoxy resin, and the polyfunctional epoxy resin has a molecular weight of 650 or less.

[6] A sixth mode of the present invention is the thermosetting resin composition of the fifth mode, wherein the polyfunctional epoxy resin is a polyfunctional epoxy resin having three or more epoxy groups per molecule.

[7] A seventh mode of the present invention is the thermosetting resin composition of any one the first to sixth modes, which is used for laminating on a roughened surface of a metallic member, wherein the roughened surface has a surface roughness Ra value of 0.5 μm or more and 2 μm or less and a surface roughness Rz value of 2 μm or more and 12 μm or less, as measured in accordance with JIS B 0601 (2001).

[8] An eighth mode of the present invention is a thermosetting resin composition including boron nitride agglomerated particles, wherein when a composite molded article is produced by laminating the thermosetting resin composition on a roughened surface of a metallic member, the roughened surface having a surface roughness Ra value of 0.5 μm or more and 2 μm or less and a surface roughness Rz value of 2 μm or more and 12 μm or less, as measured in accordance with JIS B 0601 (2001), by heat pressing at an applied pressure of less than 70 $kgf/cm^2$ and a temperature of 40 to 300°C during pressurization, to thereby laminate a sheet-like cured product on the metallic member, an interface delamination rate when observing a laminated interface between the metallic member and the sheet-like cured product in a cross-sectional SEM image is 0.8% or less, and a breakdown voltage (BDV) of the composite molded article is 5 kV or more, and a thermal conductivity in a thickness direction of a sheet-like cured product formed by molding the thermosetting resin composition into a sheet and curing is 12 W/mK or more.

[9] A ninth mode of the present invention is the thermosetting resin composition of any one the first to eighth modes, wherein the boron nitride agglomerated particles include boron nitride agglomerated particles having a card-house structure.

[10] A tenth mode of the present invention is the thermosetting resin composition of any one the first to ninth modes, which has a sheet form having a thickness of 50 μm or more and 400 μm or less.

[11] An eleventh mode of the present invention is a resin cured product using the thermosetting resin composition of any one the first to tenth modes.

[12] A twelfth mode of the present invention is a composite molded article including the resin cured product of the eleventh mode and a metallic member.

[13] A thirteenth mode of the present invention is the composite molded article of the twelfth mode, wherein the metallic member has a roughened surface having a surface roughness Ra value of 0.5 μm or more and 2 μm or less and a surface roughness Rz value of 2 μm or more and 12 μm or less, as measured in accordance with JIS B 0601 (2001).

[14] A fourteenth mode of the present invention is the composite molded article of the twelfth or thirteenth mode, wherein the metallic member is made of copper.

[15] A fifteenth mode of the present invention is a resin cured product including boron nitride agglomerated particles as an inorganic filler, wherein a proportion of the boron nitride agglomerated particles in the resin cured product is 40% by volume or more and 50% by volume or less, and a proportion of the inorganic filler other than the boron nitride agglomerated particles in the resin cured product is 7% by volume or less.

[16] A sixteenth mode of the present invention is a composite molded article, including: a metallic member having a roughened surface having a surface roughness Ra value of 0.5 μm or more and 2 μm or less and a surface roughness Rz value of 2 μm or more and 12 μm or less, as measured in accordance with JIS B 0601 (2001); and a resin cured product provided on the roughened surface, wherein the resin cured product is the resin cured product of the eleventh or fifteenth mode.

[17] A seventeenth mode of the present invention is a composite molded article including a resin cured product layer provided on a roughened surface of a metallic member, the roughened surface having a surface roughness Ra value of 0.5 μm or more and 2 μm or less and a surface roughness Rz value of 2 μm or more and 12 μm or less, as measured in accordance with JIS B 0601 (2001), wherein an interface delamination rate when observing a laminated interface between the metallic member of the composite molded article and the resin cured product layer in a cross-sectional SEM image is 0.8% or less, a breakdown voltage (BDV) of the composite molded article is 5 kV or more, a thermal conductivity in a thickness direction of the resin cured product formed layer is 12 W/mK or more, and the resin cured product contains boron nitride agglomerated particles.

[18] A eighteenth mode of the present invention is the composite molded article of the seventeenth mode, wherein the resin cured product layer is composed of a resin cured product containing boron nitride agglomerated particles as an inorganic filler, and a proportion of the boron nitride agglomerated particles in the resin cured product is 40% by volume or more and 50% by volume or less, and a proportion of the inorganic filler other than the boron nitride agglomerated particles in the resin cured product is 7% by volume or less.

## Advantageous Effects of Invention

When a sheet formed by molding the thermosetting resin composition proposed by the present invention is

closely adhered by pressing against an adherend having a roughened surface, even when pressed with a low pressing force, specifically, an applied pressure of less than 70 kgf/$cm^2$, because the sheet can deform by following the irregularities on the roughened surface of the adherend, the occurrence of gaps that form between the adherend and the sheet and/or sheet-like cured product formed by curing the sheet can be suppressed, and adhesion with the roughened surface of the adherend and voltage resistance can be increased without impairing thermal conductivity.

Brief Description of Drawing

[Figure 1] Figure 1 is a schematic diagram of a particle cross-sectional view of an example of boron nitride agglomerated particles having a card-house structure.
[Figure 2] Figure 2 is a diagram for illustrating a method of calculating an interface delamination rate in the examples described later.
[Figure 3] Figure 3(A) is a cross-sectional SEM photographed in Example 1, which will be described later, and is a cross-sectional SEM of each of an upper joining portion and a lower joining portion between a sheet-like resin cured product and a copper plate in a composite molded article produced using the sheet-like resin composition obtained in Example 1, and Figure 3(B) is an enlarged view thereof.
[Figure 4] Figure 4(A) is, similarly, is a cross-sectional SEM photographed in Comparative Example 1, which will be described later, and Figure 4(B) is an enlarged view thereof.

Description of Embodiments

An example of embodiments of the present invention will be described in detail below. However, the present invention is not limited to the following embodiments, and can be modified in various ways without departing from the spirit of the present invention.

<<Subject thermosetting resin composition>>

A thermosetting resin composition according to one example of the embodiments of the present invention (referred to as "subject thermosetting resin composition") relates to, as described above, a thermosetting resin composition that contains an epoxy resin as a main component resin and boron nitride agglomerated particles as an inorganic filler, which was developed to increase adhesion when a sheet-like cured product of the subject thermosetting resin composition, that is, a sheet formed by molding the subject thermosetting resin composition into a sheet and curing (also referred to as "subject thermal conductive resin sheet") is laminated on an adherend having a roughened surface. The subject thermosetting resin composition is characterized by limiting a content proportion of the inorganic filler other than the boron nitride agglomerated particles, and by limiting the content of the boron nitride agglomerated particles to a predetermined range.

Boron nitride agglomerated particles easily absorb a resin due to the structure of the particles, and thus in conventional thermally conductive resin sheets, as a conductive filler, it is usual to use boron nitride agglomerated particles in combination with another inorganic filler such as non-agglomerated boron nitride agglomerated particles or alumina particles.

However, inorganic fillers other than boron nitride agglomerated particles, for example, aluminum oxide particles, aluminum nitride particles, boron nitride particles, and the like, are harder and less deformable than boron nitride agglomerated particles, and so when a thermally conductive resin sheet is laminated on an adherend having a roughened surface by pressing with a low pressing force, the sheet cannot deform to follow the irregularities on the roughened surface of the adherend. As a result, gaps (voids) may occur between the thermally conductive resin sheet and the roughened surface of the adherend, causing a reduction in adhesion.

Accordingly, the content proportion of inorganic filler other than boron nitride agglomerated particles is limited and the content of boron nitride agglomerated particles is limited to a predetermined range, so that, even when laminated on an adherend having a roughened surface by pressing with a low pressing force, adhesion can be increased by suppressing the occurrence of gaps (voids) between the adherend and the thermally conductive resin sheet, and further, a decrease in thermal conductivity can be suppressed.

As used herein, "roughened surface" means a non-smooth surface having an irregular structure, and a typical example is, as described later, a surface having a surface roughness Ra value of 0.5 μm or more and 2 μm or less and a surface roughness Rz value of 2 μm or more and 12 μm or less, as measured in accordance with JIS B 0601 (2001).

In the present invention, "thermosetting resin composition" means a resin composition that is curable by heat. In other words, it suffices that the resin composition has a degree of curing that leaves room for further curing by heat. Thus,

the resin composition may have already been cured to a state that leaves room for curing (also referred to as "preliminarily cured"), or may be in a state of not yet having been cured (referred to as "uncured").

The subject thermosetting resin composition may be in the form of any of a powder, a slurry, a liquid, or a solid, or may be a molded article formed into an arbitrary shape such as a sheet.

The subject thermosetting resin composition can be molded into a sheet and cured to form a sheet-like cured product, that is, the subject thermally conductive resin sheet.

<Composition of subject thermosetting resin composition>

The subject thermosetting resin composition contains an epoxy resin, as a thermosetting resin, as a main component resin, boron nitride agglomerated particles as an inorganic filler, and optionally, an inorganic filler other than the boron nitride agglomerated particles and a thermosetting resin other than the epoxy resin. It is preferable that the composition further include, if necessary, another polymer, a curing agent, a curing accelerator, an organic solvent, and other components.

The "main component resin" is the component having the highest mass proportion of the total solid content excluding the inorganic filler from the subject thermally conductive resin composition. The mass proportion of the main resin component may be, of the total solid content excluding the inorganic filler, 30% by mass or more, of that, 50% by mass or more, of that, 70% by mass or more, of that, 80% by mass or more, and of that, 90% by mass or more (including 100% by mass).

In the present invention, "resin" refers to an organic compound excluding low molecular weight organic compounds, for example, an organic compound having a molecular weight of 100 or more. Therefore, for example, "epoxy resin" can be read as "epoxy compound", "main resin component" can be read as "main component organic compound", and "thermosetting resin" can be read as "thermosetting compound".

<Boron nitride agglomerated particles>

The boron nitride agglomerated particles are particles formed by agglomerating primary particles composed of boron nitride.

The subject thermosetting resin composition preferably contains "boron nitride agglomerated particles" as a thermally conductive filler from the viewpoint that, for example, there are fewer problems with moisture absorption during heat molding, toxicity is lower, thermal conductivity can be efficiently increased, and high insulation properties can be imparted to the subject thermally conductive resin sheet.

The shape of the boron nitride agglomerated particles is preferably spherical.

The agglomerated structure of the boron nitride agglomerated particles is preferably a card-house structure from the viewpoint of improving thermal conductivity. Therefore, it is preferable that the boron nitride agglomerated particles include boron nitride agglomerated particles having a card-house structure. That is, the agglomerated structure of the boron nitride agglomerated particles may have a structure other than the card-house structure. However, at this stage, it is preferable to have an agglomerated structure of boron nitride agglomerated particles.

The agglomerated structure of the boron nitride agglomerated particles can be confirmed using a scanning electron microscope (SEM).

A card-house structure is a structure in which plate-shaped particles are laminated in a complicated manner without orientation, and is described in "Ceramics 43 No. 2" (2008, published by the Ceramic Society of Japan). More specifically, a card-house structure is a structure in which a flat surface of the primary particles forming an agglomerated particle is in contact with the end surface of another primary particle existing within the agglomerate particle. A schematic diagram of the card-house structure is shown in Figure 1.

Such agglomerated particles having a card-house structure have an extremely high breaking strength due to their structure, and do not collapse even in the pressurizing process performed during sheet forming of the subject thermally conductive resin sheet. Therefore, the primary particles, which are normally oriented in the longitudinal direction of the subject thermally conductive resin sheet, can be made to exist in random directions. Therefore, when agglomerated particles having a card-house structure are used, it is possible to further increase the proportion of the ab-plane of the primary particles oriented in the thickness direction of the subject thermally conductive resin sheet. As a result, heat can be effectively conducted in the thickness direction of the sheet, and thermal conductivity in the thickness direction can be further enhanced.

In addition, the boron nitride agglomerated particles having a card-house structure can be produced by, for example, the method described in International Publication No. WO 2015/119198.

When using boron nitride agglomerated particles having a card-house structure, the particles may be surface-treated with a surface treatment agent.

As the surface treatment agent, for example, a known surface treatment agent used in a silane coupling treatment

and the like can be used. Generally, there is often no direct affinity or adhesion between a thermally conductive filler and a thermosetting resin. The same applies when using boron nitride agglomerated particles having a card-house structure as a thermally conductive filler. It is thought that by increasing the adhesion at the interface of the thermally conductive filler and the matrix resin through a chemical treatment, it is possible to further reduce thermal conductivity attenuation at the interface.

By using boron nitride agglomerated particles as the thermally conductive filler used in the subject thermosetting resin composition, the particle size can be increased compared to a thermally conductive filler that uses primary particles as they are.

By increasing the particle size of the thermally conductive filler, the heat transfer path through the thermally conductive filler via the thermosetting resin having a low thermal conductivity can be reduced, and therefore an increase in thermal resistance in the heat transfer path in the thickness direction can be reduced.

From the above viewpoint, the lower limit of the maximum particle size of the boron nitride agglomerated particles is preferably 20 μm or more, more preferably 30 μm or more, and further preferably 40 μm or more. On the other hand, the upper limit of the maximum particle size is preferably 300 μm or less, more preferably 200 μm or less, further preferably 100 μm or less, and still further preferably 90 μm or less.

Further, the average particle size of the boron nitride agglomerated particles is not particularly limited, but among that, the average particle size is preferably 5 μm or more, more preferably 10 μm or more, and in particular is further preferably 15 μm or more. In addition, the average particle size is preferably 100 μm or less, and more preferably 90 μm or less. By setting the average particle size of the boron nitride agglomerated particles to 5 μm or more, the number of particles in the subject thermosetting resin composition, subject thermally conductive resin sheet, and cured products of these is relatively small. As a result, the number of interfaces between particles is reduced, and so thermal resistance decreases, and the thermal conductivity of the subject thermally conductive resin sheet can be increased. Moreover, by setting the average particle size to be equal to or less than the upper limit value, the surface smoothness of a cured product using the subject thermosetting resin composition can be increased.

By setting the average particle size or maximum particle size of the boron nitride agglomerated particles to be equal to or less than the above upper limit value, a high-quality film without surface roughness can be formed when the boron nitride agglomerated particles are included in the matrix resin. By setting the average particle size or maximum particle size to be equal to or more than the above lower limit value, there are fewer interfaces between the matrix resin and the boron nitride agglomerated particles, and as a result thermal resistance is decreased, a high thermal conductivity can be achieved, and a sufficient effect of improving thermal conductivity as a thermally conductive filler, which is required for power semiconductor devices, can be obtained.

Further, the influence of the thermal resistance at the interface between the matrix resin and the boron nitride agglomerated particles on the thickness of the subject thermally conductive resin sheet is thought to become significant when the size of the boron nitride agglomerated particles relative to the thickness of the subject thermally conductive resin sheet is 1/10 or less. In particular, in the case of a power semiconductor device, in many cases the subject thermally conductive resin sheet that is used will have a thickness of from 100 μm to 300 μm, and so from the viewpoint of thermal conductivity, the maximum particle size of the boron nitride agglomerated particles is preferably larger than the above lower limit value.

In addition, by setting the maximum particle size of the boron nitride agglomerated particles to be equal to or more than the above lower limit value, not only is the increase in thermal resistance caused by the interface between the boron nitride agglomerated particles and the matrix resin suppressed, but also the number of required heat conduction paths decreases, and the probability of linkages from one surface to another surface in the thickness direction of the subject thermally conductive resin sheet increases.

On the other hand, by setting the maximum particle size of the boron nitride agglomerated particles to equal to or less than the above upper limit value, protrusion of the boron nitride agglomerated particles onto the surface of the subject thermally conductive resin sheet is suppressed, and a good surface shape without surface roughness can be obtained. As a result, when producing a sheet laminated with a copper substrate, the sheet has sufficient adhesion and excellent withstand voltage characteristics can be obtained.

The ratio (maximum particle size/thickness) of the size (maximum particle size) of the boron nitride agglomerated particles to the thickness of the subject thermally conductive resin sheet is preferably 0.3 or more and 1.0 or less, and more preferably, of that, 0.35 or more or is 0.95 or less, and of that, 0.4 or more or 0.9 or less.

The maximum particle size and average particle size of the boron nitride agglomerated particles can be measured by, for example, the following method.

The maximum particle size and average particle size of the boron nitride agglomerated particles used as a raw material can be determined by measuring the particle size distribution of a sample obtained by dispersing the boron nitride agglomerated particles in a solvent, specifically, a sample in which the boron nitride agglomerated particles are dispersed in a pure water medium containing a dispersion stabilizer, using a laser diffraction/scattering particle size distribution analyzer, and then determining the maximum particle size Dmax and the average particle size D50 of the boron nitride

agglomerated particles from the obtained particle size distribution.

Here, Dmax and D50 are the maximum particle size and cumulative volume 50% particle size in the volume-based particle size distribution obtained by a measurement using a laser diffraction scattering particle size distribution measurement method.

Further, the maximum particle size and average particle size can also be determined using a dry particle size distribution measuring device such as Morphologi G3 (manufactured by Malvern).

For the maximum particle size and average particle size of the boron nitride agglomerated particles in the subject thermosetting resin composition or subject thermally conductive resin sheet as well, the maximum particle size Dmax and the average particle size D50 can be measured using the same method as above by dissolving and removing the thermosetting resin in a solvent (including a heating solvent), or, by making the thermosetting resin swell in order to reduce the adhesion strength with the boron nitride agglomerated particles, then physically removing the thermosetting resin and further heating the resin component in the air for ashing and removal.

On the other hand, regarding the maximum particle size of the boron nitride agglomerated particles in the subject thermosetting resin composition or subject thermally conductive resin sheet, it is also possible to determine the maximum particle size by directly observing a cross section of ten or more arbitrary boron nitride agglomerated particles in the subject thermosetting resin composition or subject thermally conductive resin sheet using a scanning electron microscope, a transmission electron microscope, and a Raman spectrometer, an atomic force microscope, or the like. Further, it is also possible to determine the average particle size by directly observing ten or more arbitrary boron nitride agglomerated particles, and taking the arithmetic mean value of the diameters of the particles.

In addition, when a particle is non-spherical, the longest diameter and the shortest diameter are measured, and the average value thereof is taken as the particle size of the particle.

The breaking strength of the boron nitride agglomerated particles is preferably 20 MPa or less, more preferably, of that, 15 MPa or less, and further preferably, of that, 10 MPa or less.

By setting the breaking strength of the boron nitride agglomerated particles to 20 MPa or less, the portions where the boron nitride agglomerated particles are in contact with each other deform, and can make surface contact with each other. Therefore, while maintaining high thermal conductivity inside the boron nitride agglomerated particles, the contact thermal resistance at the interfaces of the boron nitride agglomerated particles and the interface between the metal substrate and the subject thermally conductive resin sheet, which will be described later, can be reduced, and the overall thermal conductivity can be improved.

However, if the breaking strength of the boron nitride agglomerated particles is too small, the particles will be easily deformed by the pressure used to produce the molded article, and thermal conductivity tends not to improve. Therefore, the breaking strength of the boron nitride agglomerated particles is preferably 2.5 MPa or more, and more preferably, of that, 3.0 MPa or more, of that, 3.5 MPa or more, and of that, 4.0 MPa or more.

The breaking strength can be calculated using the following formula by subjecting one particle to a compression test according to JIS R 1639-5. Usually, the particle is measured at five or more points and taking the average value thereof.

$$\text{Formula: } Cs = 2.48\ P/\pi d^2$$

Cs: Breaking strength (MPa)
P: Destructive test force (N)
d: Particle size (mm)

The elastic modulus of the boron nitride agglomerated particles is preferably 48 MPa or more, and more preferably, of that, 50 MPa or more, and of that, 55 MPa or more.

If the elastic modulus of the boron nitride agglomerated particles is within the above range, it is possible to prevent the boron nitride agglomerated particles from plastically deforming in the direction of the press pressure and the agglomerated structure from collapsing. On the other hand, the upper limit value of the elastic modulus is not particularly limited. However, from the viewpoint of easily obtaining sufficient deformation, the elastic modulus of the boron nitride agglomerated particles is preferably 2000 MPa or less, more preferably 1500 MPa or less, and further preferably 1000 MPa or less.

The elastic modulus of the boron nitride agglomerated particles can be calculated using the following formula from the test force at the time of break and the compressive displacement at that time using the device used to measure the breaking strength.

$$E = 3 \times (1-\nu^2) \times P / 4 \times (d/2)^{1/2} \times Y^{3/2}$$

("E" is the elastic modulus (MPa), "ν" is Poisson’s ratio, "P" is the destructive test force (N), "d" is the particle size (mm), and

"Y" is the compressive displacement (mm). It is noted that Poisson's ratio can be assumed to be constant (0.13).)

(Content proportion of boron nitride agglomerated particles)

The content proportion of the boron nitride agglomerated particles in the subject thermosetting resin composition is preferably 40% by volume or more and 50% by volume or less with respect to a total of 100% by volume of the total solid content of the thermally conductive resin composition.

By limiting the content of the boron nitride agglomerated particles to the above range, even when a sheet composed of the subject thermosetting resin composition is laminated on an adherend having a roughened surface by pressing with a low pressing force, the sheet can deform by following the irregularities on the roughened surface, thereby suppressing the occurrence of gaps (voids) between the adherend and the sheet, and increasing adhesion.

From this viewpoint, the content proportion of the boron nitride agglomerated particles in the total solid content of the subject thermosetting resin composition is preferably 40% by volume or more, of that, more preferably 42% by volume or more, and of that, further preferably 44% by volume or more. On the other hand, the content proportion is preferably 50% by volume or less, of that, more preferably 49.5% by volume or less, and of that, further preferably 49% by volume or less.

<Other inorganic filler>

The subject thermosetting resin composition may optionally contain an inorganic filler other than the boron nitride agglomerated particles (also referred to as "other inorganic filler").

The other inorganic filler is preferably composed of particles having thermal conductivity (also referred to as "thermally conductive filler"). Among these, the thermally conductive filler preferably has a thermal conductivity of 2.0 W/m·K or more, particularly 3.0 W/m·K or more, particularly 5.0 W/m·K or more, and particularly more preferably 10.0 W/m·K or more.

Examples of the other inorganic filler include fillers having electrical insulation properties that are composed only of carbon, fillers composed of a metal carbide or a metalloid carbide, metal oxide or metalloid oxide, metal nitride or metalloid nitride, and the like.

Examples of fillers having electrical insulation properties that are composed only of carbon include diamond (thermal conductivity: approximately 2000 W/m·K).

Examples of the metal carbide or metalloid carbide include silicon carbide (thermal conductivity: approximately 60 to 270 W/m·K), titanium carbide (thermal conductivity: approximately 21 W/m·K), and tungsten carbide (thermal conductivity: approximately 120 W/m·K).

Examples of the metal oxide or metalloid oxide include magnesium oxide (thermal conductivity: approximately 40 W/m·K), aluminum oxide (thermal conductivity: approximately 20 to 35 W/m·K), zinc oxide (thermal conductivity: approximately 54 W/m·K), yttrium oxide (thermal conductivity: approximately 27 W/m·K), zirconium oxide (thermal conductivity: approximately 3 W/m·K), ytterbium oxide (thermal conductivity: approximately 38.5 W/m·K), beryllium oxide (thermal conductivity: approximately 250 W/m·K), and "SiAlON" (ceramic made of silicon, aluminum, oxygen, and nitrogen, thermal conductivity: approximately 21 W/m·K).

Examples of the metal nitride or metalloid nitride include boron nitride (thermal conductivity in the plane direction of plate-like particles of hexagonal boron nitride (h-BN): approximately 200 to 500 W/m·K), aluminum nitride (thermal conductivity: approximately 160 to 285 W/m·k), and silicon nitride (thermal conductivity: approximately 30 to 80 W/m·K).

The other inorganic filler may be used alone or in combination of two or more.

From the viewpoint of electrical insulation properties, the volume resistivity of the other inorganic filler at 20°C is preferably $10^{13}$ Ω·cm or more, and in particular $10^{14}$ Ω·cm or more is more preferable.

Among the above, a metal oxide, a metalloid oxide, a metal nitride, or a metalloid nitride is preferable from the viewpoint of easily achieving sufficient electrical insulation properties of the subject thermally conductive resin sheet. Specific examples of such thermally conductive fillers include aluminum oxide ($Al_2O_3$, volume resistivity: >$10^{14}$ Ωcm), aluminum nitride (AlN, volume resistivity: >$10^{14}$ Ωcm), boron nitride (BN, volume resistivity: >$10^{14}$ Ωcm) silicon nitride ($Si_3N_4$, volume resistivity: >$10^{14}$ Ω·cm), and silica ($SiO_2$, volume resistivity: >$10^{14}$ Ω·cm).

Of those, aluminum oxide, aluminum nitride, and boron nitride are preferred, and aluminum oxide and boron nitride are particularly preferred since they can impart high insulation properties to the subject thermally conductive resin sheet.

The other inorganic filler may have an indefinite particle shape, a spherical shape, a whisker shape, a fiber shape, a plate shape, an agglomerate shape, or a shape of a mixture thereof.

Of those, the shape of the thermally conductive of the present invention is preferably spherical.

In addition, as used herein, "spherical" usually means a shape having an aspect ratio (ratio of major axis to minor axis) of 1 or more and 2 or less, preferably 1 or more and 1.75 or less, more preferably 1 or more and 1.5 or less, and further preferably 1 or more and 1.4 or less.

The aspect ratio is determined by arbitrarily selecting 10 or more particles from an image of a cross section of the subject thermosetting resin composition or subject thermally conductive resin sheet photographed with a scanning electron microscope (SEM), determining the ratio of the major axis to the minor axis of each particle, and calculating the average value.
The average particle size of the other inorganic filler is, from the viewpoint of increasing thermal conductivity, preferably 0.1 μm or more, more preferably 0.15 μm or more, and further preferably 0.2 μm or more. On the other hand, from the viewpoint of improving insulation properties, the average particle size is preferably 30 μm or less, more preferably 25 μm or less, and further preferably 22 μm or less.
The average particle size of the other inorganic filler is, with respect to 100% of the average particle size of the above-described boron nitride agglomerated particles, from the viewpoint of increasing thermal conductivity, preferably 0.01% or more, more preferably 0.02% or more, and further preferably 0.03% or more. On the other hand, from the viewpoint of improving insulation properties, the average particle size is preferably 10% or less, more preferably 9% or less, and further preferably 8% or less.
The average particle size of the inorganic particles used as the raw material may be the cumulative volume 50% particle size (D50) in a volume-based particle size distribution obtained by a measurement using a laser diffraction scattering particle size distribution measurement method.
As a specific example of the measurement method, the particle size distribution of a sample in which inorganic particles are dispersed in a solvent, specifically, a sample in which inorganic particles are dispersed in a pure water medium containing sodium hexametaphosphate as a dispersion stabilizer, is measured using a laser diffraction/scattering particle size distribution analyzer LA-920 (manufactured by Horiba, Ltd.), and the average particle size D50 of the inorganic particles can be determined from the obtained particle size distribution.
The average particle size can also be determined using a dry particle size distribution measuring device such as Morphologi G3 (manufactured by Malvern).
On the other hand, the average particle size of the inorganic filler in the subject thermosetting resin composition or subject thermally conductive resin sheet can be determined by directly observing a cross section of ten or more arbitrary boron nitride agglomerated particles in the subject thermosetting resin composition or subject thermally conductive resin sheet using a scanning electron microscope, a transmission electron microscope, and a Raman spectrometer, an atomic force microscope, or the like, and taking the arithmetic mean value of the diameters of the particles.
In addition, when a particle is non-spherical, the longest diameter and the shortest diameter are measured, and the average value thereof is taken as the average particle size of the particle.

(Content of other inorganic filler)

The content of the other inorganic filler, that is, inorganic filler other than the above-described boron nitride agglomerated particles, is preferably 7% by volume or less with respect to a total of 100% by volume of the total solid content of the subject thermosetting resin composition.
The other inorganic filler is harder and less deformable than the boron nitride agglomerated particles, and so when a sheet is laminated on an adherend having a roughened surface by pressing with a low pressing force, the sheet cannot deform to follow the irregularities on the roughened surface of the adherend. As a result, gaps may occur between the sheet and the roughened surface of the adherend, causing a reduction in adhesion. Therefore, the content of the other inorganic filler is, with respect to a total of 100% by volume of the total solid content of the subject thermally conductive resin composition, preferably 7% by volume or less, more preferably 6% by volume or less, further preferably 5.5% by volume or less, still further preferably 3% by volume or less, even still further preferably 1% by volume or less, even still further preferably 0.5% by volume or less, even still further preferably 0.1% by volume or less, and most preferably 0% by volume.
Among that, the content ratio of the content of the other inorganic filler to the content of the boron nitride agglomerated particles (other/BN) is preferably from 0 to 0.5.
The content ratio (other/BN) is preferably 0 or more because this increases the fluidity of the boron nitride agglomerated particles. On the other hand, the content ratio is preferably 0.5 or less because thermal conductivity is not lowered and the sheet easily follows the irregularities on the roughened surface.

(Total inorganic filler content)

The total inorganic filler content, which is the total content of the boron nitride agglomerated particles and the other inorganic filler, is preferably 40% by volume or more and 57% by volume or less with respect to a total of 100% by volume of the total solid content of the subject thermally conductive resin composition.
If the total inorganic filler content is 40% by volume or more, thermal conductivity can be improved, while if the total inorganic filler content is 57% by volume or less, adhesion and insulation properties can be improved.
From this viewpoint, the total inorganic filler content is, with respect to a total of 100% by volume of the total solid

content of the subject thermally conductive resin composition, preferably 42% by volume or more, and more preferably, of that, 43% by volume or more, and of that, 45% by volume or more. On the other hand, the total inorganic filler content is preferably 55% by volume or less, and more preferably, of that, 54% by volume or less, and of that, 53% by volume or less.

From the same viewpoint, the total inorganic filler content is, with respect to a total of 100% by mass of the total solid content of the subject thermally conductive resin composition, preferably 50% by mass or more, and more preferably, of that, 53% by mass or more, and of that, 55% by mass or more. On the other hand, the total inorganic filler content is preferably 80% by mass or less, and more preferably, of that, 75% by mass or less, and of that, 72% by mass or less.

<Epoxy resin>

The subject thermosetting resin composition preferably contains an epoxy resin as the main resin component. Among thermosetting resins, epoxy resins are superior in terms of viscosity, heat resistance, hygroscopicity, and ease of handling.

The term "epoxy resin" is a general term for a compound having one or more oxirane rings (epoxy groups) in one molecule. The oxirane ring (epoxy group) included in the epoxy resin may be either an alicyclic epoxy group or a glycidyl group. From the viewpoint of reaction rate or heat resistance, a glycidyl group is more preferable.

Examples of the epoxy resin include an epoxy group-containing silicon compound, an aliphatic epoxy resin, a bisphenol A-type or F-type epoxy resin, a novolak epoxy resin, an alicyclic epoxy resin, a glycidyl ester epoxy resin, a polyfunctional epoxy resin, and a polymeric epoxy resin.

The epoxy resin may be a compound containing an aromatic oxirane ring (epoxy group). Specific examples include a bisphenol-type epoxy resin obtained by glycidylation of a bisphenol such as bisphenol A, bisphenol F, bisphenol AD, bisphenol S, tetramethylbisphenol A, tetramethylbisphenol F, tetramethylbisphenol AD, tetramethylbisphenol S, and tetrafluorobisphenol A, a biphenyl type epoxy resin, an epoxy resin obtained by glycidylation of a dihydric phenol such as dihydroxynaphthalene and 9,9-bis(4-hydroxyphenyl)fluorene, an epoxy resin obtained by glycidylation of a trisphenol such as 1,1,1-tris(4-hydroxyphenyl) methane, an epoxy resin obtained by glycidylation of a tetrakisphenol such as 1,1,2,2-tetrakis(4-hydroxyphenyl)ethane, and a novolak-type epoxy resin obtained by glycidylation of a novolak such as phenol novolak, cresol novolak, bisphenol A novolak, and brominated bisphenol A novolak.

From the viewpoint of compatibility with the inorganic filler, the density of the epoxy resin is preferably from 0.8 to 1.5 g/cm$^3$, of that, more preferably 0.9 g/cm$^3$ or more or 1.4 g/cm$^3$ or less, and of that, further preferably 1.0 g/cm$^3$ or more or 1.3 g/cm$^3$ or less.

The epoxy resin may be an epoxy resin having a relatively low molecular weight of 100 or more or 630 or less, and of that, 200 or more or 600 or less, or a high molecular weight epoxy resin having a mass average molecular weight of 10,000 or more, of that, 20,000 or more, and of that, 30,000 or more, for example, from 30,000 to 40,000.

Among these, it is preferable that the epoxy resin contain either one or both types of a "high molecular weight epoxy resin" and a "polyfunctional epoxy resin", which will be described later.

In addition, examples of epoxy resins other than the high molecular weight epoxy resins and polyfunctional epoxy resins included in the subject thermosetting resin composition include, but are not limited to, one or more selected from various bisphenol-type epoxy resins obtained by glycidylation of a bisphenol such as a bisphenol A-type epoxy resin and a bisphenol F-type epoxy resin, various biphenyl-type epoxy resins obtained by glycidylation of a biphenol, an epoxy resin obtained by glycidylation of an aromatic compound having two hydroxyl groups such as dihydroxynaphthalene and 9,9-bis(4-hydroxyphenyl)fluorene, an epoxy resin obtained by glycidylation of a trisphenol such as 1,1,1-tris(4-hydroxyphenyl) methane, an epoxy resin obtained by glycidylation of a tetrakisphenol such as 1,1,2,2-tetrakis(4-hydroxyphenyl)ethane, a novolak-type epoxy resin obtained by glycidylation of a novolak such as phenol novolak, cresol novolak, bisphenol A novolak, and brominated bisphenol A novolak, a silicone-containing epoxy resin, and the like.

It is preferable that the epoxy resin accounts for from 30 to 100% by mass of the thermosetting resin included in the subject thermosetting resin composition, and more preferably, of that, 40% by mass or more, of that, 50% by mass or more, of that, of that, 60% by mass or more, and of that, 70% by mass or more.

It is noted that the epoxy resin at this time also includes the high molecular weight epoxy resin described below.

(High molecular weight epoxy resin)

A high molecular weight epoxy resin can be used as the epoxy resin that is the main resin component, and can also be used together with a low molecular weight epoxy resin like that described above. Further, a high molecular weight epoxy resin can also be used as a preferable example of a polymer having a mass average molecular weight of 10,000 or more, which will be described later.

Examples of the high molecular weight epoxy resin include phenoxy resins having at least one skeleton selected from the group consisting of a bisphenol A type skeleton, a bisphenol F type skeleton, a bisphenol A/F mixed type skeleton, a naphthalene skeleton, a fluorene skeleton, a biphenyl skeleton, an anthracene skeleton, a pyrene skeleton, a xanthene

skeleton, an adamantane skeleton, and a dicyclopentadiene skeleton.

Examples of the high molecular weight epoxy resin include an epoxy resin having at least one structure selected from the structure represented by the following formula (1) (hereinafter sometimes referred to as "structure (1)") and a structure represented by the following formula (2) (hereinafter sometimes referred to as "structure (2)").

[C1]

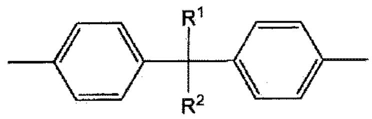

(1)

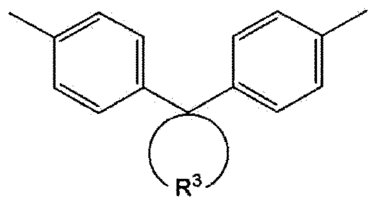

(2)

In formula (1), $R^1$ and $R^2$ each represent an organic group, and at least one of which is an organic group having a molecular weight of 16 or more. In formula (2), $R^3$ represents a divalent cyclic organic group.

As used herein, "organic group" includes any group containing a carbon atom. Specific examples include an alkyl group, an alkenyl group, and an aryl group. These may be substituted with a halogen atom, a group having a hetero group, and/or another hydrocarbon group. The same also applies below.

Further, examples of high molecular weight epoxy resins include an epoxy resin having a structure represented by the following formula (3) (hereinafter sometimes referred to as "structure (3)").

[C2]

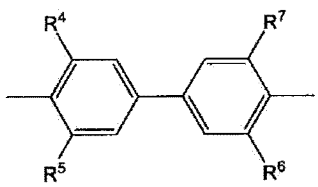

(3)

In formula (3), $R^4$, $R^5$, $R^6$, and $R^7$ each represent an organic group having a molecular weight of 15 or more.

In the above formula (1), at least one of $R^1$ and $R^2$ represents an organic group having a molecular weight of 16 or more, and preferably from 16 to 1000, for example an alkyl group such as an ethyl group, a propyl group, a butyl group, a pentyl group, a hexyl group, and a heptyl group, and an aryl group such as a phenyl group, a tolyl group, a xylyl group, a naphthyl group, and a fluorenyl group. $R^1$ and $R^2$ may both be organic groups having a molecular weight of 16 or more, or one of $R^1$ and $R^2$ may be an organic group having a molecular weight of 16 or more and the other may be an organic group having a molecular weight of 15 or less or a hydrogen atom. From the viewpoint of easily controlling handling properties such as resin viscosity, and the strength of cured product, preferably one of $R^1$ and $R^2$ is an organic group having a molecular weight of 16 or more and the other is an organic group having a molecular weight of 15 or less, and in particular, one of $R^1$ and $R^2$ is a methyl group and the other is a phenyl group.

In the above formula (2), $R^3$ is a divalent cyclic organic group, which may be an aromatic ring structure such as a benzene ring structure, a naphthalene ring structure, or a fluorene ring structure, or may be an aliphatic ring structure such as cyclobutane, cyclopentane, or cyclohexane. Further, these may independently have a substituent such as a hydrocarbon group or a halogen atom. The divalent bond may be a divalent group located on a single carbon atom or may be a divalent group located on different carbon atoms. Preferable examples include a divalent aromatic group having from 6 to 100 carbon atoms and a group derived from a cycloalkane having from 2 to 100 carbon atoms, such as cyclopropane and cyclohexane. In particular, from the viewpoint of easily controlling handling properties such as resin viscosity, and the strength of cured product, $R^3$ is preferably a 3,3,5-trimethyl-1,1-cyclohexylene group represented by the following formula (4) (hereinafter sometimes referred to as "structure (4)").

[C3]

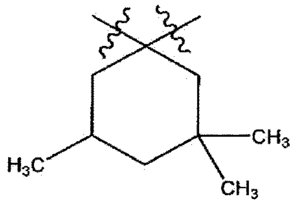

(4)

In the above formula (3), $R^4$, $R^5$, $R^6$, and $R^7$ each represent an organic group having a molecular weight of 15 or more. Preferably, $R^4$, $R^5$, $R^6$, and $R^7$ are each an alkyl group having a molecular weight of from 15 to 1000, and from the viewpoint of easily controlling handling properties such as resin viscosity, and the strength of cured product, it is particularly preferable that all of $R^4$, $R^5$, $R^6$, and $R^7$ are methyl groups.

The high molecular weight epoxy resin is particularly preferably an epoxy resin including any one of structures (1) and (2) and the structure (3) from the viewpoint of achieving both a reduction in moisture absorption and retaining the strength of the subject thermally conductive resin sheet, which is the obtained cured product.

This high molecular weight epoxy resin includes more hydrophobic hydrocarbons and aromatic structures than a general epoxy resin having a bisphenol A or bisphenol F skeleton, and so by adding the high molecular weight epoxy resin, the moisture absorption amount of the subject thermally conductive resin sheet, which is the obtained cured product, can be reduced.

Further, from the viewpoint of reducing the moisture absorption amount, it is preferable that the high molecular weight epoxy resin includes a large amount of the structures (1), (2), and (3), which are hydrophobic structure. Specifically, an epoxy resin having a mass average molecular weight of 10, 000 or more is preferable, an epoxy resin having a mass average molecular weight of 20,000 or more is more preferable, and an epoxy resin having a mass average molecular weight of 30,000 or more, for example from 30,000 to 40,000, is further preferable.

In addition, it is preferable that the high molecular weight epoxy resin is more hydrophobic, and from this viewpoint, a larger epoxy equivalent of the epoxy component is better. Specifically, 5,000 g/equivalent or more is preferable, and 7,000 g/equivalent or more, for example, from 8,000 to 15,000 g/equivalent, is more preferable.

The mass average molecular weight of the epoxy resin is a value measured by gel permeation chromatography in terms of polystyrene.

Further, epoxy equivalent is defined as "the mass of an epoxy resin containing 1 equivalent of epoxy groups", and can be measured in accordance with JIS K7236.

This high molecular weight epoxy resin may be used alone, or in combination of two or more.

The content of the high molecular weight epoxy resin is, with respect to 100% by mass of the total solid content excluding the inorganic filler from the subject thermosetting resin composition, preferably 10% by mass or more and less than 30% by mass.

It is preferable to set the content of the high molecular weight epoxy resin to 10% by mass or more because the retention force of the inorganic filler and film formability can be maintained, and to set the content to less than 30% by mass because strength during curing can be maintained.

From this viewpoint, the content of the high molecular weight epoxy resin is, with respect to 100% by mass of the total solid content excluding the inorganic filler from the subject thermosetting resin composition, preferably 10% by mass or more and less than 30% by mass, and more preferably, of that, 13% by mass or more and 29% by mass or less, and of that, 15% by mass or more and 28% by mass or less.

(Polyfunctional epoxy resin)

By including a polyfunctional epoxy resin in the subject thermosetting resin composition, the viscosity before curing can be lowered, the elastic modulus after curing can be improved, and as a result heat resistance can be improved.

From the viewpoint of increasing the storage modulus of the cured product after thermosetting, in particular the storage modulus at high temperatures, which is important in cases such as power semiconductors that generate a large amount of heat, the polyfunctional epoxy resin is preferably an epoxy resin having two or more oxirane rings (epoxy groups) in one molecule, and of those, an epoxy resin having three or more oxirane rings (epoxy groups) in one molecule is more preferable, and an epoxy compound having four or more glycidyl groups is still further preferable. By having a plurality of oxirane rings (epoxy groups), in particular glycidyl groups, in one molecule, the crosslinking density of the cured product is improved, and the subject thermally conductive resin sheet, which is the cured product obtained, has a higher strength. As a result, when internal stress occurs in the subject thermally conductive resin sheet during a moisture absorption reflow

test, the subject thermally conductive resin sheet retains its shape without deforming or breaking, and thus it is possible to suppress the generation of gaps such as voids in the subject thermally conductive resin sheet.

Further, from the viewpoint of increasing the storage modulus of the subject thermally conductive resin sheet after thermosetting, the molecular weight of the polyfunctional epoxy resin is preferably 650 or less, in particular, 100 or more or 630 or less, more preferably, of that, particularly 200 or more or 600 or less, and further preferably, 200 or more or 550 or less.

Adding such a polyfunctional epoxy resin makes it possible to introduce a highly polar oxirane ring (epoxy group) in a high density, thereby increasing the effects of physical interactions such as van der Waals forces and hydrogen bonds. For example, the adhesion between the subject thermosetting resin composition and/or subject thermally conductive resin sheet formed from the subject thermosetting resin composition and a conductor can be improved.

In addition, by adding the polyfunctional epoxy resin, the storage modulus of the subject thermosetting resin composition and/or subject thermally conductive resin sheet can be increased, which allows a strong anchor effect to develop and the adhesion between the subject thermosetting resin composition and/or subject thermally conductive resin sheet and the conductor to be improved after a cured product of the subject thermosetting resin composition has penetrated into irregularities on the surface of the conductor, which is an adherend.

On the other hand, by introducing the polyfunctional epoxy resin, the hygroscopicity of the subject thermosetting resin composition and/or subject thermally conductive resin sheet tends to increase, but by improving the reactivity of the oxirane ring (epoxy group), the amount of hydroxyl groups during the reaction can be reduced, which allows the increase in hygroscopicity to be suppressed. Further, by combining the above-described high molecular weight epoxy resin and polyfunctional epoxy resin to produce the subject thermosetting resin composition, it becomes possible for the subject thermosetting resin composition and/or subject thermally conductive resin sheet to achieve both high elasticity and low moisture absorption.

As a specific example of the polyfunctional epoxy resin, a polyfunctional epoxy resin having three or more epoxy groups per molecule and having a molecular weight of 650 or less is preferable. For example, EX321L, DLC301, DLC402, and the like, manufactured by Nagase ChemteX can be used.

These polyfunctional epoxy resins may be used alone or in combination of two or more.

It is preferable that the polyfunctional epoxy resin does not include an amine-based or amide-based structure containing a nitrogen atom from the viewpoint of achieving lower moisture absorption and high crosslinking. Further, for the purpose of controlling the viscosity, that is, the coating properties, of the subject thermosetting resin composition, and also from the viewpoint of achieving low moisture absorption, it is preferable not to include a structure, such as an aromatic ring, that is rigid and causes intermolecular interactions.

The content of the polyfunctional epoxy resin is preferably 5% by mass or more and 80% by mass or less with respect to 100% by mass of the total solid content excluding the inorganic filler from the subject thermosetting resin composition.

The content of the polyfunctional epoxy resin is preferably 5% by mass or more because the elastic modulus of the cured product of the thermosetting resin composition can be maintained, and the content is preferably 80% by mass or less because the water absorption rate does not become too high.

From this viewpoint, the content of the polyfunctional epoxy resin is, with respect to 100% by mass of the total solid content excluding the inorganic filler from the subject thermosetting resin composition, preferably 5% by mass or more and 80% by mass or less, and more preferably, of that, 10% by mass or more or 70% by mass or less, and of that, 15% by mass or more or 50% by mass or less.

When using the high molecular weight epoxy resin and the polyfunctional epoxy resin together, from the viewpoint of the film formability and elastic modulus of the subject thermally conductive resin sheet, the content of the polyfunctional epoxy resin is, with respect to 100 parts by mass of the content of the high molecular weight epoxy resin, preferably 20 parts by mass or more and 300 parts by mass or less, and more preferably, of that, 30 parts by mass or more and 250 parts by mass or less, and of that, 40 parts by mass or more and 200 parts by mass or less.

<Thermosetting resin other than epoxy resin>

The subject thermosetting resin composition may optionally include a thermosetting resin other than the epoxy resin.

The thermosetting resin other than the epoxy resin may be any resin that is cured by heat. Examples include a phenol resin, a polycarbonate resin, an unsaturated polyester resin, a urethane resin, a melamine resin, and a urea resin.

(Content proportion of thermosetting resin)

The content of the thermosetting resin including the epoxy resin is preferably from 5 to 99% by mass with respect to 100% by mass of the total solid content excluding the inorganic filler from the subject thermosetting resin composition.

The content of the thermosetting resin is preferably 5% by mass or more because moldability is improved. On the other hand, the content is preferably 99% by mass or less because this ensures that other components can be contained, and thermal conductivity can be increased.

From this viewpoint, the content of the thermosetting resin is, with respect to 100% by mass of the total solid content excluding the inorganic filler from the subject thermosetting resin composition, preferably from 5 to 99% by mass, and more preferably, of that, 10% by mass or more, of that, 20% by mass or more, of that, 30% by mass or more, of that, 40% by mass or more, and of that, 50% by mass or more. The content of the thermosetting resin is more preferably 98% by mass or less.

<Polymer>

The subject thermosetting resin composition may optionally contain a polymer having a mass average molecular weight of 10,000 or more instead of or together with the high molecular weight epoxy resin.

Such a high molecular weight polymer can act as a resin matrix component and/or binder resin component in the subject thermosetting resin composition, and can improve the film forming properties of the subject thermosetting resin composition.

The polymer may be either a thermoplastic resin or a thermosetting resin.

Examples of the thermoplastic resin and the thermosetting resin include thermoplastic resins such as polyphenylene ether, polyphenylene sulfide, polyarylate, polysulfone, polyether sulfone, polyether ether ketone, and polyether ketone. Further, as the thermoplastic resin and the thermosetting resin, a group of heat-resistant resins called "super engineering plastics", such as thermoplastic polyimide, thermosetting polyimide, benzoxazine, and a reaction product of polybenzoxazole and benzoxazine, can also be used. In addition, a styrenic polymer such as styrene and alkylstyrene; a (meth)acrylic polymer such as alkyl (meth)acrylate and glycidyl (meth)acrylate; a styrene-(meth)acrylic polymer such as styrene-glycidyl methacrylate; a polyvinyl alcohol derivative such as polyvinyl butyral, polyvinyl benzal, and polyvinyl acetal; a norbornene-based polymer containing a norbornene compound; and a phenoxy resin can also be used. Of those, a phenoxy resin is preferable in terms of heat resistance and compatibility with the thermosetting resin.

The thermoplastic resin and the thermosetting resin may each be used alone or in combination of two or more. Either of the thermoplastic resin or the thermosetting resin may be used, or the thermoplastic resin and the thermosetting resin may be used together.

The content of the polymer having a mass average molecular weight of 10,000 (when using in combination with a high molecular weight epoxy resin, the content also includes the high molecular weight epoxy resin) is preferably 10% by mass or more and less than 30% by mass with respect to 100% by mass of the total solid content excluding the inorganic filler from the subject thermosetting resin composition.

It is preferable to contain 10% by mass or more of the polymer due to maintaining retention force of the inorganic filler and film formability, and to contain the polymer in a proportion of less than 30% by mass due to maintaining strength during curing.

From this viewpoint, the content of the polymer is, with respect to 100% by mass of the total solid content excluding the inorganic filler from the subject thermosetting resin composition, preferably 10% by mass or more, and more preferably, of that, 13% by mass or more, and of that, 15% by mass or more. On the other hand, the content is preferably less than 30% by mass, and more preferably, of that, less than 29% by mass.

<Curing agent>

The subject thermosetting resin composition may optionally contain a curing agent.

Examples of the curing agent include a phenol resin, a compound having a heterocyclic structure containing a nitrogen atom (hereinafter sometimes referred to as "nitrogen-containing heterocyclic compound"), an acid anhydride having an aromatic skeleton or an alicyclic skeleton, a hydrogenated product of such an acid anhydride, and a modified product of such an acid anhydride. These curing agents may be used alone or in combination of two or more.

By using these preferable curing agents, it is possible to obtain a resin cured product having an excellent balance among heat resistance, moisture resistance, and electrical properties.

Examples of the phenol resin include phenol novolak, o-cresol novolak, p-cresol novolak, t-butylphenol novolak, dicyclopentadiene cresol, polyparavinylphenol, bisphenol A type novolak, xylylene-modified novolak, decalin-modified novolak, poly(di-o-hydroxyphenyl) methane, poly(di-m-hydroxyphenyl)methane, and poly (di-p-hydroxyphenyl)methane. Among those, to further improve the flexibility and flame retardance of the thermosetting resin composition, and to improve the mechanical properties and heat resistance of the resin cured product, a novolak type phenol resin having a rigid main chain skeleton or a phenol resin having a triazine skeleton is preferable.

Further, in order to improve the flexibility of the uncured thermosetting resin composition and the toughness of the resin cured product, a phenol resin having an allyl group is preferable.

Examples of the heterocyclic structure of the nitrogen-containing heterocyclic compound include a structure derived from imidazole, triazine, triazole, pyrimidine, pyrazine, pyridine, azole, and the like. An imidazole-based compound or a triazine-based compound is preferable from the viewpoint of the insulation properties of thermosetting resin composition and improved adhesion to metals.

Examples of preferable imidazole-based compounds and triazine compounds include 2-ethyl-4-methylimidazole, 2-phenylimidazole, 1-benzyl-2-methylimidazole, 1-benzyl-2-phenylimidazole, 1-cyanoethyl-2-undecylimidazole, 1-cyanoethyl-2-ethyl-4-methylimidazole, 2-phenyl-4-methylimidazole, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'methylimidazolyl-(1'))]-ethyl-s-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, 2-phenyl-4-methyl-5-hydroxymethylimidazole, 2,4-diamino-6-vinyl-s-triazine, a 2,4-diamino-6-vinyl-s-triazine isocyanuric acid adduct, 2,4-diamino-6-methacryloyloxyethyl-s-triazine, and a 2,4-diamino-6-methacryloyloxyethyl-s-triazine isocyanuric acid adduct.

Among those, in particular, a compound having a structure derived from imidazole and a compound having a structure derived from triazine are preferable, and a compound having a structure derived from triazine is particularly preferable because such a compound has high resin compatibility and a high reaction activation temperature, which enables the curing rate and the physical properties after curing to be easily adjusted, and so as a result even further improvements can be made in the storage stability of the subject thermosetting resin composition and the adhesive strength after heat molding. The heterocyclic structure of the nitrogen-containing heterocyclic compound is particularly preferably a structure derived from 1,3,5-triazine. Further, it is also possible to have a plurality of the structural moieties exemplified above.

Depending on the structure, the nitrogen-containing heterocyclic compound may contain a curing catalyst, which will be described later. Therefore, the subject thermosetting resin composition can contain the nitrogen-containing heterocyclic compound as a curing catalyst.

The nitrogen-containing heterocyclic compound may be used alone or in combination of two or more. Further, one molecule may have a plurality of heterocyclic structures at the same time.

The molecular weight of the nitrogen-containing heterocyclic compound is preferably 1,000 or less, and more preferably 500 or less.

The acid anhydride having an aromatic skeleton, hydrogenated product of such an acid anhydride, or modified product of such an acid anhydride are not particularly limited.

The acid anhydride having an alicyclic skeleton, hydrogenated product of such an acid anhydride, or modified product of such an acid anhydride is preferably an acid anhydride having a polyalicyclic skeleton, a hydrogenated product of such an acid anhydride, or a modified product of such an acid anhydride, or is preferably an acid anhydride having an alicyclic skeleton obtained by an addition reaction between a terpene compound and maleic anhydride, a hydrogenated product of such an acid anhydride, or a modified product of such an acid anhydride.

The content of the curing agent is preferably from 0 to 70% by mass, and particularly from 0 to 55% by mass, with respect to 100% by mass of the total solid content excluding the inorganic filler from the subject thermosetting resin composition. By setting the content of the curing agent to be equal to or more than the above lower limit value, sufficient curing performance can be obtained, and by setting the content to be equal to or less than the above upper limit value, the reaction can proceed effectively, the crosslinking density can be improved, the strength can be increased, and film forming properties are improved as well.

<Curing accelerator>

The subject thermosetting resin composition can optionally contain a curing catalyst as a curing accelerator in order to adjust the curing rate and the physical properties of the cured product if necessary.

It is preferable to appropriately select the curing catalyst depending on the thermosetting resin component and the type of curing agent.

Specific examples of the curing catalyst include a chain or cyclic tertiary amine, an organic phosphorus compound, a diazabicycloalkene such as a quaternary phosphonium salt or an organic acid salt, and an imidazole. Further, an organic metal compound, a quaternary ammonium salt, a metal halide, and the like can also be used. Examples of the organometallic compound include zinc octylate, tin octylate, and an aluminum acetylacetone complex.

These may be used alone or in combination of two or more.

Among those, particularly from the viewpoint of storage stability, heat resistance, and curing rate, a compound containing an imidazole (referred to as "imidazole-based compound") is preferable.

Examples of preferable imidazole-based compounds include 2-ethyl-4-methylimidazole, 2-phenylimidazole, 1-benzyl-2-methylimidazole, 1-benzyl-2-phenylimidazole, 1-cyanoethyl-2-undecylimidazole, 1-cyanoethyl-2-ethyl-4-methylimidazole, 2-phenyl-4-methylimidazole, 1-cyanoethyl-2-phenylimidazolium trimellitate, 2,4-diamino-6-[2'-methylimidazolyl-(1')]-ethyl-s-triazine, 2,4-diamino-6-[2'-undecylimidazolyl-(1')]-ethyl-s-triazine, 2,4-diamino-6-[2'-ethyl-4'methylimidazolyl-(1'))]-ethyls-triazine, a 2,4-diamino-6-[2'-methylimidazolyl-(1')]-ethyl-s-triazine isocyanuric acid adduct, a 2-phenylimidazole isocyanuric acid adduct, 2-phenyl-4,5-dihydroxymethylimidazole, and 2-phenyl-4-methyl-5-hydroxymethylimidazole.

In particular, by using an imidazole-based compound having a melting point of 100°C or higher, and more preferably 200°C or higher, a cured product having excellent storage stability and adhesion can be obtained. Further, from the viewpoint of adhesive properties, a curing catalyst that includes a nitrogen-containing heterocyclic compound other than the above-mentioned imidazole ring is more preferable.

The content of the curing catalyst is, with respect to 100% by mass of the total solid content excluding the inorganic filler from the subject thermosetting resin composition, preferably from 0.1 to 10% by mass, and particularly preferably from 0.1 to 5% by mass. By setting the content of the curing catalyst to be equal to or more than the above lower limit, the progress of the curing reaction can be sufficiently promoted to achieve good curing, and by setting the content to be equal to or less than the above upper limit, the curing rate will not be too fast, and therefore the storage stability of the subject thermosetting resin composition can be good.

<Organic solvent>

The subject thermosetting resin composition may optionally contain an organic solvent, if necessary for example, in order to improve coating properties when forming a sheet-like cured product through a coating process.

Examples of the organic solvent that can be contained in the subject thermosetting resin composition include methyl ethyl ketone, cyclohexanone, propylene glycol monomethyl ether acetate, butyl acetate, isobutyl acetate, and propylene glycol monomethyl ether.

These organic solvents may be used alone or in combination of two or more.

When the subject thermosetting resin composition contains an organic solvent, the content is appropriately determined depending on the ease of handling and the like during production of the subject thermally conductive resin sheet. Usually, it is preferable to use the organic solvent so that the solid content (total of components other than the solvent) concentration in the subject thermosetting resin composition is from 10 to 90% by mass, and in particular 40% by mass or more and 80% by mass or less.

In the case of forming the subject thermosetting resin composition into a sheet, it is preferable to use the organic solvent so that the solid content (total of components other than the solvent) concentration in the subject thermosetting resin composition is 95% by mass or more, more preferably 97% by mass or more, further preferably 98% by mass or more, and still further preferably 99% by mass or more.

<Other components>

The subject thermosetting resin composition may contain other components in addition to the components described above.

Examples of the other components include a dispersant, a thermoplastic resin, an organic filler, an inorganic filler, an additive such as a silane coupling agent that improves the interfacial adhesive strength between an inorganic filler and the resin component, an additive that can be expected to have an effect of increasing the adhesion strength between a resin sheet and a metal plate in a similar manner to a silane coupling agent and the like, an insulating carbon component such as a reducing agent, a viscosity modifier, a thixotropic agent, a flame retardant, a colorant, a phosphorus-based, phenol-based, or other type of antioxidant, a phenol acrylate or other type of process stabilizer, a heat stabilizer, a hindered amine radical scavenger (HAAS), an impact modifier, a processing aid, a metal deactivator, a copper inhibitor, an antistatic agent, and a bulking agent.

When these additives are used, they may be added in amounts generally within the range of amounts used for these purposes.

<Thickness>

The thickness of the sheet-like resin composition formed by molding the subject thermosetting resin composition into a sheet is preferably 50 μm or more, more preferably 60 μm or more, further preferably 70 μm or more, and still further preferably 100 μm or more. On the other hand, the upper limit value of the thickness is preferably 400 μm or less, more preferably 300 μm or less, further preferably 250 μm or less, further preferably 200 μm or less, and further preferably 180 μm or less.

<Physical properties of subject thermosetting resin composition>

The subject thermosetting resin composition can have the following physical properties.

(Interface delamination rate)

When the subject thermosetting resin composition is used to produce a composite molded article by laminating the thermosetting resin composition on a roughened surface of a metallic member, the roughened surface having a surface roughness Ra value of 0.5 μm or more and 2 μm or less and a surface roughness Rz value of 2 μm or more and 12 μm or less, as measured in accordance with JIS B 0601 (2001), by heat pressing at an applied pressure of less than 70 $kgf/cm^2$ and a temperature of 40 to 300°C during pressurization, to thereby laminate a sheet-like cured product on the metallic member, an interface delamination rate when observing a laminated interface between the metallic member and the sheet-like cured product in a cross-sectional SEM image can be 0.8% or less, of that, 0.7% or less, and of that, 0.6% or less.

By the heat pressing, the subject thermosetting resin composition becomes a sheet-like cured product, that is, the subject thermally conductive resin sheet.

(Breakdown voltage (BDV))

When the subject thermosetting resin composition is used to produce a composite molded article by laminating the thermosetting resin composition on a roughened surface of a metallic member, the roughened surface having a surface roughness Ra value of 0.5 μm or more and 2 μm or less and a surface roughness Rz value of 2 μm or more and 12 μm or less, as measured in accordance with JIS B 0601 (2001), by heat pressing at an applied pressure of less than 70 $kgf/cm^2$ and a temperature of 40 to 300°C during pressurization, to thereby laminate a sheet-like cured product on the metallic member, a breakdown voltage (BDV) of the composite molded article can be 5 kV or more, of that, 5.5 kV or more, and of that, 6 kV or more.

(Thermal conductivity)

The subject thermosetting resin composition can have a thermal conductivity in the thickness direction of a sheet-like cured product formed by molding the subject thermosetting resin composition into a sheet and curing, of 12 W/mK or more, of that, 13 W/mK or more, and even of that, 14 W/mK or more.

<Uses of subject thermosetting resin composition>

The subject thermosetting resin composition can be used in various applications where thermal conductivity is required.

<Thermally conductive resin sheet>

By molding the subject thermosetting resin composition into a sheet and curing, a resin sheet having thermal conductivity, that is, the "subject thermally conductive resin sheet", can be obtained.

By curing the subject thermosetting resin composition, effects such as high adhesion after adhering the subject thermosetting resin composition to an adherend, thermal conductivity, and high insulation properties can be obtained.

The thermal conductivity of the subject thermally conductive resin sheet in the thickness direction can be 12 W/mK or more, of that, 13 W/mK or more, and even of that, 14 W/mK or more. By setting the thermal conductivity in the thickness direction to be equal to or more than the above lower limit value, the thermally conductive resin sheet can be suitably used for power semiconductor devices and the like that operate at high temperatures.

The thermal conductivity can be adjusted based on the type of thermosetting resin, the physical property value of the thermosetting resin such as melt viscosity, the structure, oil absorption amount, and content of the boron nitride agglomerated particles, the method of mixing the thermosetting resin and the boron nitride agglomerated particles, the conditions in the heating and kneading process described below, and the like.

The thermal conductivity in the thickness direction of the subject thermally conductive resin sheet can be measured by the following method.

For example, the thermal resistance value of thermally conductive resin sheets having the same composition and thickness produced under the same conditions is measured using a thermal resistance measuring device (manufactured by Mentor Graphics Corporation, trade name "T3ster"), and determining the thermal conductivity from the slope of the graph obtained by plotting the thermal resistance value against thickness.

The lower limit value of the thickness of the subject thermally conductive resin sheet is preferably 50 μm or more, more preferably 60 μm or more, further preferably 70 μm or more, and still further preferably 100 μm or more. On the other hand, the upper limit value of the thickness is preferably 400 μm or less, more preferably 300 μm or less, further preferably 250 μm or less, still further preferably 200 μm or less, and still further preferably 180 μm or less.
By setting the thickness of the subject thermally conductive resin sheet to 50 μm or more, sufficient voltage resistance characteristics can be ensured. On the other hand, by setting the thickness to 400 μm or less, in particular when using the thermally conductive resin sheet for a power semiconductor device and the like, it is possible to achieve a smaller and thinner device, and as a result of the greater thinness, it is also possible to obtain an effect of a reduction in thermal resistance in the thickness direction as compared to thermally conductive layer having insulating properties made of a ceramic material.

(Production method of subject thermally conductive resin sheet)

An example of a method for producing the subject thermally conductive resin sheet will now be described.
An example of the method for producing the subject thermally conductive resin sheet includes a method including a mixing process and a press molding process.
In the mixing process, the subject thermosetting resin composition may be heated, melted and kneaded, or may be stirred and mixed at room temperature.
In the press molding process, the mixture obtained in the above mixing process may be pressed and molded into a sheet.
For the press molding method, various known press devices for molding thermosetting resins can be used. From the viewpoint of preventing resin deterioration during hot pressing, it is particularly preferable to use a vacuum press device that can reduce the amount of oxygen in the press during heating or a press device equipped with a nitrogen purge device.
The pressure in the press molding process is, in terms of the actual pressure applied on the sample, usually 2 MPa or more, preferably 3 MPa or more, and more preferably 4 MPa or more. Further, the pressure is preferably 7 MPa or less, more preferably 6.9 MPa or less, and further preferably 6.5 MPa or less.
The pressurizing time is usually 30 seconds or more, preferably 1 minute or more, more preferably 3 minutes or more, and further preferably 5 minutes or more. Further, the time is preferably 3 hours or less, more preferably 2.5 hours or less, and further preferably 2 hours or less.
If the set temperature of the press device in the press molding process, that is, the heating temperature, is such that the molding temperature is 40°C or higher, in particular 50°C or higher, and of that, in particular 80°C or higher, the resin viscosity will be low enough for shaping processing, and sufficient thickness uniformity can be imparted to the thermally conductive resin sheet. Further, the subject thermosetting resin composition can be cured. On the other hand, if the set temperature of the press device is 300°C or lower, in particular 250°C or lower, and of that, in particular 200°C or lower, deterioration of the resin itself and deterioration of the physical properties of the molded thermally conductive resin sheet can be suppressed.
If necessary, the subject thermosetting resin composition may be cured by heating after the press molding process (also referred to as a curing process).
At this time, the heating temperature is preferably from 30 to 400°C, of that, more preferably 50°C or higher, and of that, further preferably 90°C or higher. On the other hand, of that, the temperature is preferably 300°C or lower, and of that, more preferably 250°C or lower.
The above-mentioned curing by heating may be performed under pressure or without pressure. In the case of applying pressure, it is desirable to perform the curing process under the same conditions as the above-described pressing process for the same reasons as above. In addition, the pressing process and the curing process may be performed simultaneously.
In particular, in a sheet-forming process that includes a pressurizing process and a curing process, it is preferable to perform the pressurization and curing by applying a load in the above range.
The load when performing the pressurizing process and the curing process at the same time is not particularly limited. In this case, it is preferable to apply a load of 5 MPa or more on the sheet-like subject composition on the base material, more preferably 7 Pa or more, further preferably 9 MPa or more, and particularly preferably 20 MPa. Further, the load is preferably 2000 MPa or less, and more preferably 1500 MPa or less.
By setting the load when performing the pressurizing process and the curing process simultaneously to be equal to or less than the above upper limit value, a sheet-like cured product having high thermal conductivity in which the secondary particles of the agglomerated boron nitride particles are not destroyed and with no gaps in the sheet-like subject thermosetting resin composition can be obtained. Further, by setting the load to be equal to or more than the above lower limit value, contact among the inorganic filler particles is good and a heat conduction path is easily formed, and so a subject resin cured product having high thermal conductivity can be obtained.
When performing the pressurizing process and the curing process simultaneously, the pressurization time is not

particularly limited. The pressurization time is preferably 30 seconds or more, more preferably 1 minute or more, further preferably 3 minutes or more, and particularly preferably 5 minutes or more. Further, the pressurization time is preferably 1 hour or less, more preferably 30 minutes or less, and further preferably 20 minutes or less.

By setting the pressurization time to be equal to or less than the above upper limit value, it tends to be possible to suppress the production time of the sheet-like resin cured product, and to reduce production costs. By setting the pressurization time to be equal to or more than the above lower limit value, it tends to be possible to sufficiently remove the subject sheet-like resin cured product, that is, gaps and voids in the subject thermally conductive resin sheet, and to improve heat transfer performance and voltage resistance characteristics.

<Subject composite molded article>

It suffices that the composite molded article according to an example of the embodiment of the present invention (referred to as "subject composite molded article") have a resin cured product composed of the subject thermosetting resin composition, and a metallic member.

An example of the subject composite molded article is a composite molded article obtained by laminating a sheet-like cured product composed of the subject thermosetting resin composition, that is, the subject thermally conductive resin sheet, on one surface of a metallic member.

At this time, even if the surface to which the metallic member is adhered is a roughened surface, as described above, as long as the cured product is a sheet-like cured product composed of the subject thermosetting resin composition, adhesion can be increased by suppressing the occurrence of gaps (voids) between the adherend and the sheet even when laminated by pressing with a low pressing force, specifically, a low pressing force of an applied pressure of less than 70 $kgf/cm^2$.

An example of the roughened surface of the metallic member is a surface having a surface roughness Ra value of 0.5 μm or more and 2 μm or less and a surface roughness Rz value of 2 μm or more and 12 μm or less, as measured in accordance with JIS B 0601 (2001).

The surface roughness Ra is also called arithmetic mean roughness. If the surface roughness Ra is 0.5 μm or more, high adhesive strength can be expected due to an anchor effect when the resin composition is bonded and cured. If the surface roughness Ra is 2 μm or less, in particular during low-pressure pressing, the resin composition easily follows the irregularities of the resin composition, resulting in less gaps and good insulation properties. From this viewpoint, the surface roughness Ra value is more preferably 0.7 μm or more, and further preferably 0.9 μm or more. On the other hand, the surface roughness Ra is more preferably 10 μm or less, and further preferably 8 μm or less.

The surface roughness Rz is also called maximum height. If the surface roughness Rz is 2 μm or more, high adhesive strength can be expected due to an anchor effect when the resin composition is bonded and cured. If the surface roughness Rz is 12 μm or less, in particular during low-pressure pressing, the resin composition easily follows the irregularities of the resin composition, resulting in less gaps and good insulation properties. From this viewpoint, the surface roughness Rz value is more preferably 3 μm or more, and further preferably 4 μm or more. On the other hand, the surface roughness Rz is more preferably 11 μm or less, and further preferably 10 μm or less.

The surface roughness Ra and Rz are values measured in accordance with JIS B 0601 (2001), and in detail can be measured by the method described in the examples.

The metallic member is preferably composed of a material having good thermal conductivity. Among such materials, in order to increase the thermal conductivity in the laminated structure, it is preferable to use a metal material for heat dissipation, and of those, it is more preferable to use a flat metal material.

The material substance of the metal material is not particularly limited. Of those, materials made of copper such as a copper plate, materials made of aluminum such as an aluminum plate, and materials made of an aluminum alloy such as an aluminum alloy plate, are preferable because they have good thermal conductivity and are relatively inexpensive.

The method used for laminating and integrating the subject thermally conductive resin sheet and the metallic member is preferably press molding, which is a batch process.

At this time, from the viewpoint of the pressure resistance and process suitability of the adherend to be bonded on the top and bottom of the sheet, the press pressure is preferably less than 70 $kgf/cm^2$, and preferably, of that, 69 $kgf/cm^2$ or less, and of that, 65 $kgf/cm^2$ or less. On the other hand, from the viewpoint of following the irregularities on the surface of the adherend to be bonded on the top and bottom of the sheet and efficiently crushing the gaps within the sheet, the press pressure is preferably 2 $kgf/cm^2$ or more, and preferably, of that, 3 $kgf/cm^2$ or more, and of that, 4 $kgf/cm^2$ or more.

The press equipment, press conditions, and the like are the same range of press molding conditions for obtaining the thermally conductive resin sheet described above.

<Heat-dissipating circuit board>

The heat-dissipating circuit board according to an example of the embodiment of the present invention (referred

to as "subject heat-dissipating circuit board") may be any board that includes the subject thermally conductive resin sheet.

An example of a subject heat-dissipating circuit board has a structure obtained by laminating the above-described metallic member on one surface of a subject thermally conductive resin sheet, and forming a circuit substrate by, for example, an etching treatment and the like on the other surface of the subject thermally conductive resin sheet to that of the metallic member. Specifically, a "metallic member/subject thermally conductive resin sheet/conductive circuit" integrated structure is more preferable.

Examples of the state before the circuit etching include, for an integrated structure of "metallic member/subject thermally conductive resin sheet/metal layer for forming conductive circuit", a state in which the metal layer for forming the conductive circuit is flat, and is formed on the entire surface of one side of the subject thermally conductive resin sheet or formed on a part of the area of the subject thermally conductive resin sheet.

The material of the metal layer for forming the conductive circuit is not particularly limited. Generally, from the viewpoint of good electrical conductivity, good etching properties, and cost, it is preferable to form a thin copper plate having a thickness of 0.05 mm or more and 1.2 mm or less.

<Semiconductor device>

The semiconductor device according to an example of the embodiment of the present invention (referred to as "subject semiconductor device") may be any device that includes the subject heat-dissipating circuit board.

An example of the subject semiconductor device is a device that includes a structure having a silicon wafer or rewiring layer on which pre-segmented semiconductor chips are mounted formed on the subject heat-dissipating circuit board.

<Power module>

The power module according to an example of the embodiment of the present invention (referred to as "subject power module") may be any module as long as it includes the subject thermally conductive resin sheet.

An example of the subject power module is a module having the subject heat-dissipating circuit board mounted as a heat-dissipating circuit board on a power semiconductor device.

In this power semiconductor device, other than the thermally conductive resin sheet or laminated heat-dissipating sheet, conventionally known members may be used as appropriate for the aluminum wiring, sealing material, packaging material, heat sink, thermal paste, and solder.

<<Explanation of terms>>

In the present invention, unless otherwise specified, the expression "from X to Y" (X and Y are arbitrary numbers) means "X or more and Y or less", and includes the meaning "preferably larger than X" or "preferably smaller than Y".

In addition, the expression "X or more" (X is an arbitrary number) or "Y or less" (Y is an arbitrary number) are also intended to include the meaning "preferably more than X" or "preferably less than Y".

In the present invention, the term "sheet" conceptually includes sheets, films, and tapes.

Examples

Hereinafter, the present invention will be explained in more detail with reference to examples. However, the present invention is not limited to the following examples as long as the spirit of the present invention is not exceeded.

<Materials used>

The materials used in the examples and comparative examples are as follows.

(Thermosetting resin)

**[0242]** - Resin component 1: High molecular weight epoxy resin (mass average molecular weight in terms of polystyrene: 30,000, epoxy equivalent: 9,000 g/equivalent, density approximately 1.2 g/$cm^3$) having the above structure (2) ($R^3$ = structure (4)) and structure (3) ($R^4$, $R^5$, $R^6$, and $R^7$ = methyl group) produced in accordance with the method for producing an epoxy resin disclosed in the examples of Japanese Patent Laid-Open No. 2006-176658).

- Resin component 2: Polyfunctional epoxy resin manufactured by Nagase ChemteX, which includes a structure having 4 or more glycidyl groups per molecule (molecular weight: 500 or less, density approximately 1.2 g/$cm^3$)

- Resin component 3: Biphenyl type solid epoxy compound manufactured by Mitsubishi Chemical (molecular weight: approximately 400, density approximately 1.2 g/$cm^3$)

(Inorganic filler)

- Inorganic filler 1: Spherical boron nitride agglomerated particles having a card-house structure produced based on International Publication No. WO 2015/119198 (average particle size (D50) 45 μm, maximum particle size (Dmax) 90 μm)

The average particle size (D50) and maximum particle size (Dmax) of the particles of inorganic filler 1 are the maximum particle size Dmax and cumulative volume 50% particle size (average particle size D50) determined from a particle size distribution obtained by dispersing the thermally conductive filler in a pure water medium containing sodium hexametaphosphate as a dispersion stabilizer, and measuring the particle size distribution using a laser diffraction/-scattering particle size distribution analyzer LA-300 (manufactured by Horiba, Ltd.).

(Other inorganic filler)

- Inorganic filler 2: Spherical alumina particles, manufactured by Admatex

  New Mohs hardness: 9
  Volume average particle size: 6.5 μm
  Thermal conductivity: 20 to 30 W/m·K

- Inorganic filler 3: Spherical alumina particles, manufactured by Admatex

  New Mohs hardness: 9
  Volume average particle size: 0.2 μm
  Thermal conductivity: 20 to 30 W/m·K

- Inorganic filler 4: Spherical alumina particles, manufactured by Admatex

  New Mohs hardness: 9
  Volume average particle size: 7 μm
  Thermal conductivity: 20 to 30 W/m·K

The new Mohs hardness, volume average particle size, and thermal conductivity of inorganic fillers 2, 3, and 4 are catalog values. The volume average particle size is the maximum particle size Dmax and cumulative volume 50% particle size (average particle size D50) determined from a particle size distribution obtained by measuring a volume-based particle size distribution.

(Curing agent)

- Curing agent 1: "MEH-8000H" manufactured by Meiwa Plastic Industries, phenol resin curing agent

(Curing catalyst)

- Curing catalyst 1: "2E4MZ-A" manufactured by Shikoku Kasei

  2,4-diamino-6-[2'-ethyl-4'-methylimidazolyl-(17')]-ethyl-s-triazine
  (One molecule contains both an imidazole-derived structure and a triazine-derived structure)

Molecular weight: 247, properties: solid, melting point: 215 to 225°C

- Curing catalyst 2: "2PHZ-PW" manufactured by Shikoku Kasei

2-phenyl-4,5-dihydroxymethylimidazole
Molecular weight: 204, property: solid, melting point: dec. 230, and so the melting point is 230°C or higher

[Sample production, measurement, and evaluation]

The method for producing the molded articles of the examples and comparative examples, and the measurement conditions and evaluation methods, were as follows.

<Examples 1 to 3 and Comparative Examples 1 and 2>

The above-described resin components 1 to 3, inorganic fillers 1 to 3, curing agent 1, and curing catalysts 1 and 2 were each weighed as shown in Table 1 below, methyl ethyl ketone and cyclohexanone was added so that the solid content concentration was 63% by mass, and the resultant mixture was mixed using a rotation/revolution type stirring device to prepare a coating slurry.

It is noted that in Table 1, the mass of the curing catalyst is set as 1, and the mass ratio of each raw material is shown as a ratio to that mass.

The obtained coating slurry (slurry for forming a sheet) was coated on a PET base material using a doctor blade method, heated and dried at 60°C for 120 minutes, and then pressed at 42°C and 1500 kgf/$cm^2$ for 10 minutes using a pressing device to obtain a sheet-like resin composition having a thickness of 150 μm.

The total content of the methyl ethyl ketone and the cyclohexanone in the sheet-like resin composition was 1% by mass or less.

<Thermal conductivity measurement>

(Production of sample for thermal conductivity measurement)

The sheet-like resin compositions obtained in the examples and comparative examples were pressurized at 120°C and 60 kgf/$cm^2$ for 40 minutes to obtain resin cured products. Further, two, three, four, or five of the sheet-like resin compositions obtained in the examples and comparative examples were stacked, and pressure was applied thereon in the same manner as above to obtain five types of sheet-like resin compositions having different thicknesses (sheet-like resin cured products having a thickness of approximately 150 μm, approximately 300 μm, approximately 450 μm, approximately 600 μm, and approximately 750 μm).

(Thermal conductivity measurement)

The thickness, area, and thermal resistance value of the five types of sheet-like resin cured products having different thicknesses produced as above were measured as described in (1) to (3) below. Then, as described in (4) below, the thermal conductivity (25°C) in the sheet thickness direction was determined by the steady method from the slope represented by the thermal resistance value with respect to the sheet thickness (in accordance with ASTMD5470).

The probe size during measurement was φ12.8 mm, the fixing pressure was 3400 kPa, and the measurement time was 300 sec. "OIL COMPOUND (product name: G-747)" manufactured by Shin-Etsu Chemical Co., Ltd. was used to increase adhesion between the sample and the probe.

(1) Thickness: Thickness (μm) when pressed at a press pressure of 3400 kPa using a T3Ster-DynTIM manufactured by Mentor Graphics.
(2) Measurement area: Area of the portion that transfers heat ($cm^2$) when measured using a T3Ster-DynTIM manufactured by Mentor Graphics
(3) Thermal resistance value: Thermal resistance value (K/W) when pressed at a press pressure of 3400 kPa using a T3Ster-DynTIM manufactured by Mentor Graphics
(4) Thermal conductivity: The thermal resistance value of four sheets having different thicknesses was measured, and the thermal conductivity (W/m·K) was calculated from the following formula:

Formula: the thermal conductivity (W/m·K) =1/ (slope (thermal resistance value/thickness): K/(W·μm))×(area:$cm^2$)) $\times 10^{-2}$

<BDV measurement>

(Preparation of roughened copper)

The entire surface of a copper plate having a thickness of 2 mm or 0.5 mm was roughened by irradiating the surface with a pulsed fiber laser to form dimples on the surface of the copper plate.

(Metal surface roughness measurement)

Surface roughness was measured using a Surfcom TOUCH550 manufactured by Tokyo Seimitsu Co., Ltd., in accordance with JIS B 0601 (2001). The measurement was carried out by measuring the metal surface in the long axis and short axis directions under measurement conditions of an evaluation length of 25 mm and a measurement speed of 0.3 mm/s, and the average value was calculated.

The above roughened copper plate had an Ra of 1.4 μm and an Rz of 8.4 μm.

(Preparation of BDV sample)

The roughened surface of the 2 mm-thick roughened copper plate produced as described above was placed on one side of the sheet-like resin composition obtained in the examples and comparative examples, and pressure was applied for 5 minutes at 80°C and 60 kgf/cm$^2$. Next, the roughened surface of the 0.5 mm-thick roughened copper plate produced as described above was placed on the other side of the sheet-like resin composition, and pressure was applied for 30 minutes at 180°C and 60 kgf/cm$^2$ to produce a composite molded article in which a copper plate was laminated on the top and bottom of a sheet-like resin cured product. Then, the composite molded article was etched using a predetermined method to pattern the 0.5 mm copper plate, whereby a BDV sample was obtained. The pattern was such that two circular patterns with a diameter of 25 mm remained.

(BDV measurement)

The BDV sample produced as described above, that is, a composite molded article having a 0.5 mm copper plate patterned so that two circular patterns having a diameter of 25 mm remained, was immersed in Fluorinert (product number: FC-40, manufactured by 3M), and an AC voltage was applied to each of the 0.5 mm copper plate and the 2 mm copper plate. The application procedure was as follows: 0.5 kV was applied for 60 seconds, then the voltage was increased to 1.0 kV, and applied for another 60 seconds, and after that, the applied voltage was increased by 0.5 kV each time. The voltage at which insulation broke down was taken as the BDV.

Cases where the measured breakdown voltage (BDV) was 5 kV or more were evaluated as "OK (pass)", and cases where the measured breakdown voltage (BDV) was less than 5 kV were evaluated as "NG (fail)".

(SAT measurement)

The roughened surface of the 2 mm-thick roughened copper plate produced as described above was placed on one side of the sheet-like resin composition obtained in the examples and comparative examples, and pressure was applied for 5 minutes at 80°C and 60 kgf/cm$^2$. Next, the roughened surface of the 0.5 mm-thick roughened copper plate produced as described above was placed on the other side of the sheet-like resin composition, and pressure was applied for 30 minutes at 180°C and 60 kgf/cm$^2$ to produce a composite molded article in which a copper plate was laminated on the top and bottom of a sheet-like resin cured product.

In the composite molded article, the interfaces between the copper plates and the resin cured product were observed using an ultrasonic imaging device FinSAT (FS300III) (manufactured by Hitachi Power Solutions). The measurement was carried out using a probe having a frequency of 50 MHz, with the gain set to 30 dB, a pitch of 0.2 mm, and the sample placed in water. Cases where no peeling was observed at the interfaces were evaluated as "OK (pass)," and cases where interfacial peeling was observed were evaluated as "NG (fail)."

(Cross-sectional SEM measurement)

The roughened surface of the 2 mm-thick roughened copper plate produced as described above was placed on one side of the sheet-like resin composition obtained in the examples and comparative examples, and pressure was applied for 5 minutes at 80°C and 60 kgf/cm$^2$. Next, the roughened surface of the 0.5 mm-thick roughened copper plate produced as described above was placed on the other side of the sheet-like resin composition, and pressure was applied for 30 minutes at 180°C and 60 kgf/cm$^2$ to produce a composite molded article in which a copper plate was laminated on the

top and bottom of a sheet-like resin cured product.

The composite molded article was cut at an arbitrary location by shearing processing (DSW3500P (manufactured by Meiwafosis)).

Then, cross-sectional processing was performed by performing ion milling (ArBlade 5000 (manufactured by Hitachi High-Tech)) on an arbitrary part of the joining portion between the cut surface of the sheet and the upper and lower copper plates.

Then, cross-sectional SEM observation was performed on an arbitrary part of the processed area (Ultra 55 (manufactured by Zeiss), acceleration of 3 kV, 150 times magnification, secondary electron images, image size of (1024 × 768 pixels)), and SEM images were obtained by observing the joining portion between the sheet and both the upper and lower copper plates.

Figures 3 and 4 are cross-sectional SEMs of each of an upper joining portion and a lower joining portion between a sheet-like resin cured product and a copper plate in a composite molded article produced using the sheet-like resin compositions obtained in Example 1 and Comparative Example 1.

<Calculation of interface delamination rate>

As shown in Figure 2, the interface delamination rate was calculated by, first of all, connecting the two points in the deepest valleys in the image of the roughened part of the copper plate for each joining portion between the resin cured product and the upper and lower copper plates in the SEM image obtained above, taking the line between those two points to be the valley bottom line, and setting the standard length of that valley bottom line to 764 μm. However, an area was chosen that did not have large valleys with unusual heights that could be considered a scratch. The calculation was performed on an image in a range of 12 μm in size cut from the line in a direction perpendicular to the direction of the resin material.

The cut out image was binarized, and contrast areas equal to or below the copper plate and the inorganic filler and resin that are components of the resin composition were removed as gaps. The remaining area was divided by the area 12 μm × 764 μm, which is the cut out range, and multiplied by 100 to calculate a proportion value A (%) and a proportion value B (%) of each joining portion between the resin cured product and the upper and lower copper plates. Of the proportion value A and the proportion value B, the value with the larger absolute value was defined as the interface delamination rate (%).

<Measurement of curing shrinkage>

The resin components 1 to 3, curing agent 1, and curing catalysts 1 to 2 were each weighed as shown in Table 1 below, appropriate amounts of methyl ethyl ketone and cyclohexanone were added, and the resultant mixture was mixed using a rotation/revolution type stirring device to prepare a resin mixture.

This resin mixture was coated onto a PET base material using a doctor blade method, and heated and dried at 60°C for 120 minutes to produce a "sample A" in which a "resin sheet A" was laminated on the PET base material.

Further, this sample A was further heated and dried at 180°C for 30 minutes to produce a "sample B" in which a "cured resin sheet B" was laminated on a PET base material.

The density of each of sample A and sample B was measured using a density measurement kit manufactured by METTLER TOLERO, the density of the PET base material was also measured in the same way, and the density of the resin sheet A and the density of the cured resin sheet B were calculated by subtraction.

As a result, the density of sample A was 1.19 g/$cm^3$, and the density of sample B was 1.23 g/$cm^3$.

Further, from the calculation results, the curing shrinkage rate was calculated to be 3.3% based on the formula ((density of sample B) - (density of sample A))/(density of sample B) * 100.

<Vol% of each inorganic filler in the total solid content of resin cured product>

In addition, based on the above measurement result of the curing shrinkage rate, the vol% of the boron nitride agglomerated particles in the total solid content of the resin cured products of the examples and comparative examples, and the vol% of the inorganic filler other than boron nitride agglomerated particles in the total solid content of the resin cured products were calculated.

[Table 1]

| | | Example 1 | Example 2 | Example 3 | Comparative Example 1 | Comparative Example 2 |
|---|---|---|---|---|---|---|
| Composition weight ratio | Inorganic filler 1 | 175 | 194 | 188 | 217 | 218 |
| | Inorganic filler 2 | 0 | 0 | 0 | 81 | 0 |
| | Inorganic filler 3 | 0 | 37 | 22 | 0 | 80 |
| | Resin component 1 | 25 | 25 | 25 | 25 | 25 |
| | Resin component 2 | 20 | 20 | 21 | 20 | 20 |
| | Resin component 3 | 41 | 41 | 41 | 41 | 40 |
| | Curing agent 1 | 14 | 14 | 14 | 14 | 14 |
| | Curing catalyst 1 | 1 | 1 | 1 | 1 | 1 |
| | Curing catalyst 2 | 1 | 1 | 1 | 1 | 1 |
| Vol% of agglomerated boron nitride filler in resin composition | | 47.6 | 47.7 | 47.7 | 47.7 | 48 |
| Vol% of filler other than agglomerated boron nitride filler in resin composition | | 0 | 5.1 | 3.2 | 10.2 | 10 |
| Vol% of agglomerated boron nitride filler in resin cured product | | 48.4 | 48.5 | 48.5 | 48.4 | 48.7 |
| Vol% of filler other than agglomerated boron nitride filler in resin cured product | | 0 | 5.2 | 3.3 | 10.3 | 10.1 |
| Physical properties | Thermal conductivity | 15 | 14 | 14 | 16 | 14 |
| | BDV ≥ 5 kV | OK | OK | OK | NG | NG |
| | SAT | OK | OK | OK | NG | NG |
| Interface delamination rate (%) | | 0.2 | 0.56 | 0.07 | 3.09 | 0.88 |

(Consideration)

From the results of the above examples and comparative examples as well as test results conducted by the present inventors up to now, it can be seen that, in a thermosetting resin composition containing an epoxy resin as a main resin component and boron nitride agglomerated particles as an inorganic filler, by limiting the content proportion of the inorganic filler other than boron nitride agglomerated particles and limiting the content of the boron nitride agglomerated particles to a predetermined range, even when the thermally conductive resin sheet is closely adhered by pressing against an adherend having a roughened surface with a low pressing force, the occurrence of gaps that form between an adherend and a thermally conductive resin sheet can be suppressed, and good adhesion, high insulation properties, and high thermal conductivity can be achieved. Specifically, it is thought that such effects can be obtained by setting the proportion of the boron nitride agglomerated particles in the total solid content of the thermosetting resin composition to 40% by volume or more and 50% by volume or less, and the proportion of the inorganic fillers other than boron nitride agglomerated particles to 7% by volume or less.

<Examples 4 to 6 and Comparative Examples 3 and 4>

The above-described resin components 1 to 3, inorganic fillers 1 to 4, curing agent 1, and curing catalysts 1 to 2 were each weighed as shown in Table 2 below, methyl ethyl ketone and cyclohexanone was added so that the solid content concentration was 63% by mass, and the resultant mixture was mixed using a rotation/revolution type stirring device to prepare a coating slurry.
It is noted that in Table 2, the mass of the curing catalyst is set as 1, and the mass ratio of each raw material is shown as a ratio to that mass.

The obtained coating slurry (slurry for forming a sheet) was, by the same method as in Examples 1 to 3 and Comparative Examples 1 and 2, coated on a PET base material, heated and dried, and then pressed using a pressing device to obtain a sheet-like resin composition.

<Thermal conductivity measurement>

The thermal conductivity of the sheet-like resin compositions obtained in Examples 4 to 6 and Comparative Examples 3 and 4 was measured by producing samples for measuring the thermal conductivity in the same manner as in Examples 1 to 3 and Comparative Examples 1 to 2, respectively.

<BDV Measurement>

Composite molded articles serving as BDV samples were produced by the same manner as described above by placing the roughened surfaces of roughened copper plates produced in the same manner as in Examples 1 to 3 and Comparative Examples 1 to 2 on either side of the sheet-like resin compositions obtained in Examples 4 to 6 and Comparative Examples 3 and 4, and the BDV was measured in the same manner as described above.

<SAT measurement, cross-sectional SEM measurement, calculation of interface delamination rate>

Using the sheet-like resin compositions obtained in Examples 4 to 6 and Comparative Examples 3 and 4, composite molded articles were produced in the same manner as in Examples 1 to 3 and Comparative Examples 1 to 2, and the SAT measurement, cross-sectional SEM measurement, and calculation of the interface delamination rate were carried out in the same manner as described above. The results are shown in Table 2.

<Measurement of curing shrinkage>

The above-described resin components 1 to 3, curing agent 1, and curing catalysts 1 to 2 were each weighed as shown in Table 2 below, appropriate amounts of methyl ethyl ketone and cyclohexanone were added, and the resultant mixture was mixed using a rotation/revolution type stirring device to prepare a resin mixture. Sample A and sample B were produced in the same manner as in Examples 1 to 3 and Comparative Examples 1 to 2, and the densities of the resin sheet A and the cured resin sheet B were calculated in the same manner as described above.

As a result, the density of sample A was 1.19 g/cm$^3$, and the density of sample B was 1.23 g/cm$^3$.

Then, from the calculation result, the curing shrinkage rate was calculated to be 3.3% based on the formula ((density of sample B) - (density of sample A))/(density of sample B) * 100.

<Vol% of each inorganic filler in the total solid content of resin cured product>

For Examples 4 to 6 and Comparative Examples 3 and 4 as well, in the same manner as in Examples 1 to 3 and Comparative Examples 1 to 2, the vol% of the boron nitride agglomerated particles in the total solid content of the resin cured products of the examples and comparative examples, and the vol% of the inorganic filler other than boron nitride agglomerated particles in the total solid content of the resin cured products were calculated.

<Reference example 1>

Using the sheet-like resin composition obtained in Comparative Example 1, a composite molded article was produced in the same manner as in Comparative Example 1, except that non-roughened copper plates were used as the copper plate to be laminated on the sheet-like resin composition. The BDV, SAT, and cross-sectional SEM were measured in the same manner as described above, and the interface delamination rate was calculated in the same manner as described above. The results are shown in Table 2.

[Table 2]

| | | Example 4 | Example 5 | Example 6 | Comparative Example 3 | Comparative Example 4 | Reference Example 1 |
|---|---|---|---|---|---|---|---|
| Composition weight ratio | Inorganic filler 1 | 162 | 186 | 169 | 267 | 141 | 217 |
| | Inorganic filler 2 | 0 | 0 | 0 | 0 | 0 | 81 |
| | Inorganic filler 3 | 0 | 35 | 0 | 0 | 0 | 0 |
| | Inorganic filler 4 | 0 | 0 | 0 | 0 | 193 | 0 |
| | Resin component 1 | 25 | 25 | 25 | 25 | 25 | 25 |
| | Resin component 2 | 20 | 20 | 20 | 21 | 20 | 20 |
| | Resin component 3 | 40 | 40 | 41 | 41 | 40 | 41 |
| | Curing agent 1 | 14 | 14 | 14 | 14 | 14 | 14 |
| | Curing catalyst 1 | 1 | 1 | 1 | 1 | 1 | 1 |
| | Curing catalyst 2 | 1 | 1 | 1 | 1 | 1 | 1 |
| Vol% of agglomerated boron nitride filler in resin composition | | 46 | 47.1 | 47 | 57.9 | 32 | 47.7 |
| Vol% of filler other than agglomerated boron nitride filler in resin composition | | 0 | 5 | 0 | 0 | 25 | 10.2 |
| Vol% of agglomerated boron nitride filler in resin cured product | | 46.8 | 47.9 | 47.8 | 58.7 | 32.5 | 48.4 |
| Vol% of filler other than agglomerated boron nitride filler in resin cured product | | 0 | 5.1 | 0 | 0 | 25.4 | 10.3 |
| Physical properties | Thermal conductivity (W/mK) | 14 | 15 | 14 | 19 | 11 | 16 |
| | BDV ≥ 5 kV | OK | OK | OK | NG | NG | NG |
| | SAT | OK | OK | OK | NG | - | NG |
| | SAT (for unroughened copper) | - | - | - | - | - | OK |
| Interface delamination rate (%) | | 0.09 | 0.07 | 0.06 | 10.2 | - | - |
| Interface delamination rate (%) (for unroughened copper) | | - | - | - | - | - | 0.05 |

(Consideration)

It can be seen that when, as in Comparative Example 3, the proportion of boron nitride agglomerated particles in the total solid content of the thermosetting resin composition exceeded 50% by volume, the BDV was "NG", and the

delamination rate was also high.

Further, it was found that when, as in Comparative Example 4, the proportion of boron nitride agglomerated particles in the total solid content of the thermosetting resin composition was less than 40% by volume, the thermal conductivity decreased. In addition, it was also found that when the proportion of alumina as an inorganic filler other than the boron nitride agglomerated particles was more than 7% by volume, the BDV was lower.

## Claims

1. A thermosetting resin composition comprising an epoxy resin as a main component resin and boron nitride agglomerated particles as an inorganic filler, wherein
a proportion of the boron nitride agglomerated particles in a total solid content of the thermosetting resin composition is 40% by volume or more and 50% by volume or less, and a proportion of the inorganic filler other than the boron nitride agglomerated particles in the total solid content of the thermosetting resin composition is 7% by volume or less.

2. The thermosetting resin composition according to claim 1, comprising at least one compound having imidazole as a curing catalyst.

3. The thermosetting resin composition according to claim 1 or 2, which has a thermal conductivity of 12 W/mK or more after thermosetting.

4. The thermosetting resin composition according to any one of claims 1 to 3, comprising a polymer having a mass average molecular weight of 10,000 or more as the epoxy resin.

5. The thermosetting resin composition according to any one of claims 1 to 4, wherein

   the thermosetting resin composition comprises, as the epoxy resin, a polyfunctional epoxy resin, and
   the polyfunctional epoxy resin has a molecular weight of 650 or less.

6. The thermosetting resin composition according to claim 5, wherein the polyfunctional epoxy resin is a polyfunctional epoxy resin having three or more epoxy groups per molecule.

7. The thermosetting resin composition according to any one of claims 1 to 6, which is used for laminating on a roughened surface of a metallic member, wherein the roughened surface has a surface roughness Ra value of 0.5 μm or more and 2 μm or less and a surface roughness Rz value of 2 μm or more and 12 μm or less, as measured in accordance with JIS B 0601 (2001).

8. A thermosetting resin composition comprising boron nitride agglomerated particles, wherein

   when a composite molded article is produced by laminating the thermosetting resin composition on a roughened surface of a metallic member, the roughened surface having a surface roughness Ra value of 0.5 μm or more and 2 μm or less and a surface roughness Rz value of 2 μm or more and 12 μm or less, as measured in accordance with JIS B 0601 (2001), by heat pressing at an applied pressure of less than 70 $kgf/cm^2$ and a temperature of 40 to 300°C during pressurization, to thereby laminate a sheet-like cured product on the metallic member, an interface delamination rate when observing a laminated interface between the metallic member and the sheet-like cured product in a cross-sectional SEM image is 0.8% or less, and a breakdown voltage (BDV) of the composite molded article is 5 kV or more, and
   a thermal conductivity in a thickness direction of a sheet-like cured product formed by molding the thermosetting resin composition into a sheet and curing is 12 W/mK or more.

9. The thermosetting resin composition according to any one of claims 1 to 8, wherein the boron nitride agglomerated particles include boron nitride agglomerated particles having a card-house structure.

10. The thermosetting resin composition according to any one of claims 1 to 9, which has a sheet form having a thickness of 50 μm or more and 400 μm or less.

11. A resin cured product using the thermosetting resin composition according to any one of claims 1 to 10.

**12.** A composite molded article comprising the resin cured product according to claim 11 and a metallic member.

**13.** The composite molded article according to claim 12, wherein the metallic member has a roughened surface having a surface roughness Ra value of 0.5 μm or more and 2 μm or less and a surface roughness Rz value of 2 μm or more and 12 μm or less, as measured in accordance with JIS B 0601 (2001).

**14.** The composite molded article according to claim 12 or 13, wherein the metallic member is made of copper.

**15.** A resin cured product comprising boron nitride agglomerated particles as an inorganic filler, wherein a proportion of the boron nitride agglomerated particles in the resin cured product is 40% by volume or more and 50% by volume or less, and a proportion of the inorganic filler other than the boron nitride agglomerated particles in the resin cured product is 7% by volume or less.

**16.** A composite molded article, comprising:

a metallic member having a roughened surface having a surface roughness Ra value of 0.5 μm or more and 2 μm or less and a surface roughness Rz value of 2 μm or more and 12 μm or less, as measured in accordance with JIS B 0601 (2001); and
a resin cured product provided on the roughened surface,
wherein the resin cured product is the resin cured product according to claim 11 or 15.

**17.** A composite molded article comprising a resin cured product layer provided on a roughened surface of a metallic member, the roughened surface having a surface roughness Ra value of 0.5 μm or more and 2 μm or less and a surface roughness Rz value of 2 μm or more and 12 μm or less, as measured in accordance with JIS B 0601 (2001), wherein

an interface delamination rate when observing a laminated interface between the metallic member of the composite molded article and the resin cured product layer in a cross-sectional SEM image is 0.8% or less,
a breakdown voltage (BDV) of the composite molded article is 5 kV or more,
a thermal conductivity in a thickness direction of the resin cured product formed layer is 12 W/mK or more, and
the resin cured product contains boron nitride agglomerated particles.

**18.** The composite molded article according to claim 17, wherein

the resin cured product layer is composed of a resin cured product containing boron nitride agglomerated particles as an inorganic filler, and
a proportion of the boron nitride agglomerated particles in the resin cured product is 40% by volume or more and 50% by volume or less, and a proportion of the inorganic filler other than the boron nitride agglomerated particles in the resin cured product is 7% by volume or less.

Fig. 1

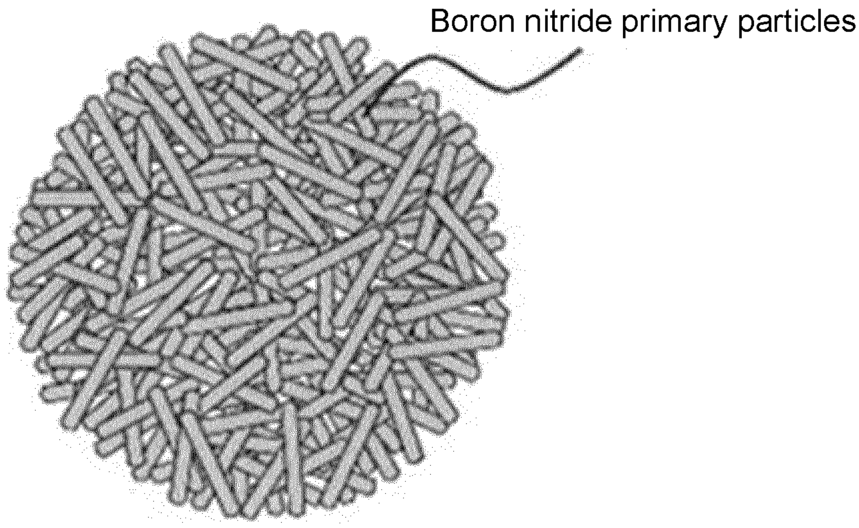
Boron nitride primary particles

Fig. 2

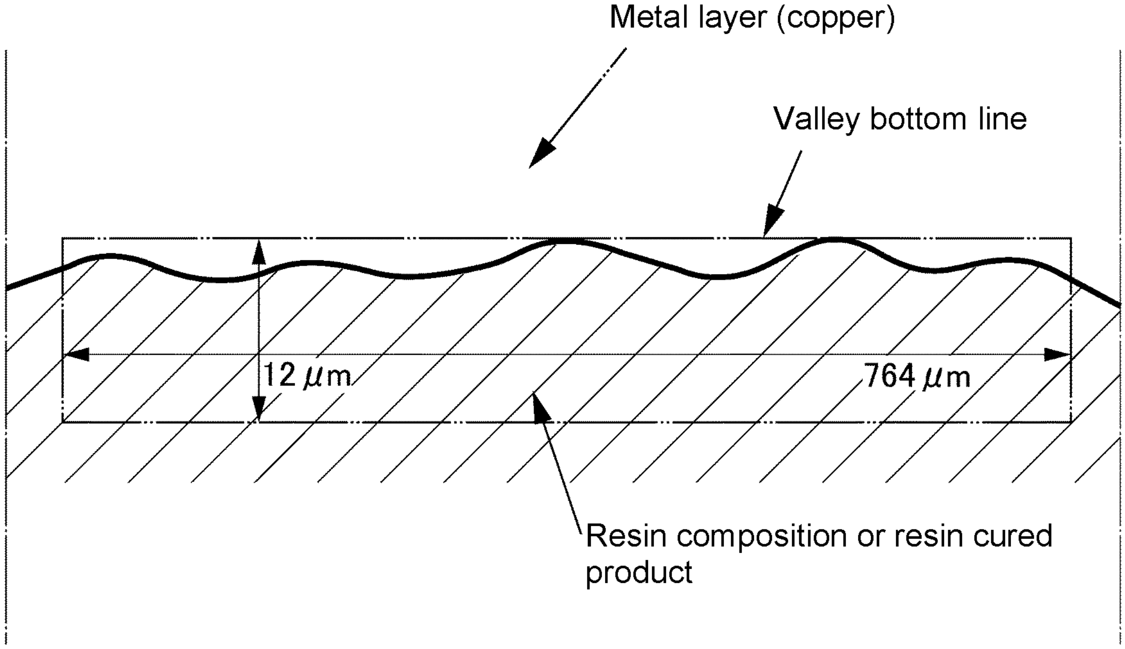
Metal layer (copper)
Valley bottom line
12 μm
764 μm
Resin composition or resin cured product

Fig. 3A

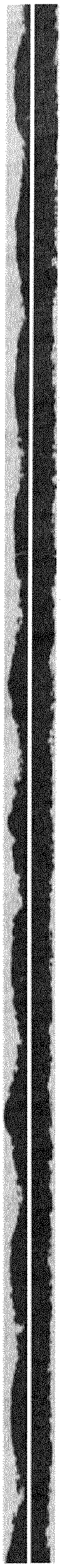

Fig. 3B

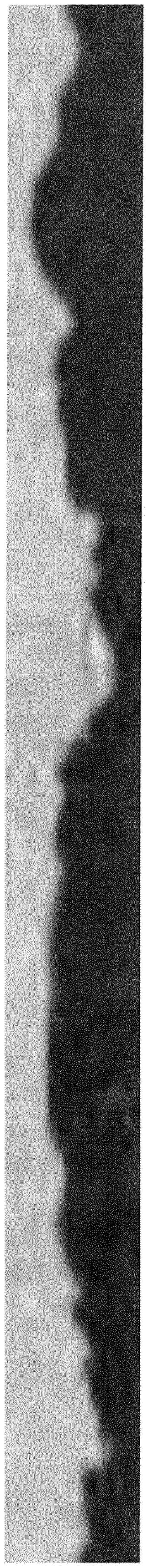

Fig. 4A

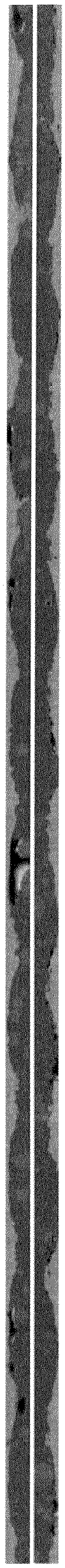

Fig. 4B

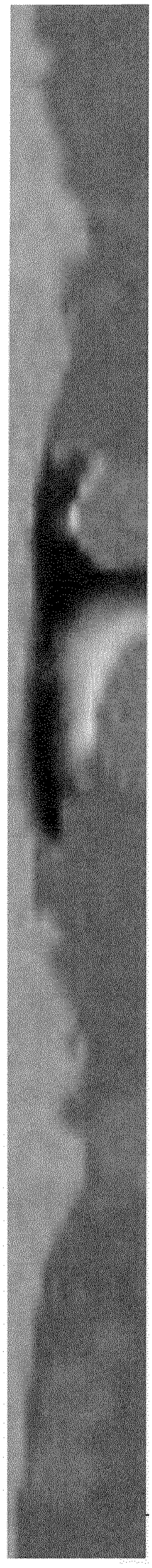

# INTERNATIONAL SEARCH REPORT

International application No.
**PCT/JP2023/006385**

**A. CLASSIFICATION OF SUBJECT MATTER**

***C08G 59/00***(2006.01)i; ***B32B 15/092***(2006.01)i; ***B32B 15/20***(2006.01)i; ***B32B 27/20***(2006.01)i; ***B32B 27/38***(2006.01)i; ***C08K 3/38***(2006.01)i; ***C08L 63/00***(2006.01)i; ***H01L 23/29***(2006.01)i; ***H01L 23/31***(2006.01)i; ***H01L 23/36***(2006.01)i; ***H01L 23/373***(2006.01)i
FI: C08G59/00; C08K3/38; C08L63/00; B32B15/092; B32B27/20 Z; B32B27/38; B32B15/20; H01L23/36 D; H01L23/36 M; H01L23/30 R

According to International Patent Classification (IPC) or to both national classification and IPC

**B. FIELDS SEARCHED**

Minimum documentation searched (classification system followed by classification symbols)

C08G59/00; B32B15/092; B32B15/20; B32B27/20; B32B27/38; C08K3/38; C08L63/00; H01L23/29; H01L23/31; H01L23/36; H01L23/373

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2017-82091 A (DENKA CO., LTD.) 18 May 2017 (2017-05-18)<br>claims, paragraphs [0009], [0020]-[0021], examples 1-9, 11 | 1-8, 10-18 |
| Y | paragraph [0001] | 9 |
| X | JP 2009-24126 A (NITTO DENKO CORPORATION) 05 February 2009 (2009-02-05)<br>claims, paragraphs [0024]-[0025], [0031]-[0032], example 1 | 1-8, 10-18 |
| Y | paragraph [0001] | 9 |
| X | JP 2015-196823 A (MITSUBISHI ELECTRIC CORPORATION) 09 November 2015 (2015-11-09)<br>claims, paragraphs [0017], [0019], [0032], example 14 | 1-6, 8, 10-12, 14-15 |
| Y | paragraph [0010] | 7, 9, 13, 16-18 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 April 2023** | **16 May 2023** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2023/006385**

**C. DOCUMENTS CONSIDERED TO BE RELEVANT**

| Category* | Citation of document, with indication, where appropriate, of the relevant passages | Relevant to claim No. |
|---|---|---|
| Y | WO 2021/085593 A1 (MITSUBISHI CHEMICAL CORPORATION) 06 May 2021 (2021-05-06)<br>paragraphs [0016], [0101]-[0104] | 7, 13, 16-18 |
| Y | paragraphs [0016], [0023]-[0024] | 9 |
| A | JP 2019-29269 A (TOYO INK SC HOLDINGS CO., LTD.) 21 February 2019 (2019-02-21) | 1-18 |

Form PCT/ISA/210 (second sheet) (January 2015)

**INTERNATIONAL SEARCH REPORT**

International application No.
**PCT/JP2023/006385**

**Box No. III Observations where unity of invention is lacking (Continuation of item 3 of first sheet)**

This International Searching Authority found multiple inventions in this international application, as follows:

Document 1: JP 2015-196823 A (MITSUBISHI ELECTRIC CORP.) 09 November 2015 (2002-11-09) claims, paragraphs [0010], [0017], [0019], [0032], example 14 (family: none)

Document 2: JP 2017-82091 A (DENKA COMPANY LIMITED) 18 May 2017 (2017-05-18) claims, paragraphs [0001], [0009], [0020]-[0021], examples 1-9, 11

Document 3: JP 2009-24126 A (NITTO DENKO CORP.) 02 April 2009 (2020-04-02) claims, paragraphs [0001], [0024]-[0025], [0031]-[0032], example 1 (Family: none)

The claims are classified into the following two inventions.

(Invention 1) Claims 1-7, 15, and the sections of claims 9-14 and 16 citing claims 1-7 and 15.

Documents 1-3 disclose the composition as in claims 1-3. Claims 1-3 lack novelty in the light of documents 1-3 and thus do not have special technical features. However, claim 4 depending from claim 1 has the special technical feature of "having a polymer with a mass average molecular mass of 10,000 or more as the epoxy resin". Therefore, claims 1-4 are classified as invention 1.

Furthermore, claims 5-7 and the sections of claims 9-14 and 16 citing claims 1-7 are dependent claims of claim 1 and inventively linked with claim 1, and thus are classified as invention 1.

Additionally, claim 15 and the section of claim 16 citing claim 15 are also inventively linked to claim 1, and thus are classified as invention 1.

(Invention 2) Claims 8, 17-18, and the sections of claims 9-14 and 16 citing claim 8

Claims 8, 17-18, and the sections of claims 9-14 and 16 citing claim 8 cannot be said to have the same or corresponding special technical features with respect to invention 1, and are not substantially identical to or similarly closely related to any of the claims.

Therefore, claims 8, 17-18, and the sections of claims 9-14 and 16 citing claim 8 cannot be classified as invention 1.

Claims 8, 17-18, and the sections of claims 9-14 and 16 citing claim 8 are classified as invention 2 due to having the special technical feature of a thermosetting composition or composite molded article in which an interfacial separation rate when a lamination interface between a metal member of a specific composite molded article and a sheet-shaped cured product are observed in a SEM cross-sectional image is 0.8% or lower, the breakdown voltage (BDV) of the composite molded article is at least 5 kV, and the thermal conductivity in the thickness direction of the sheet-shaped cured product obtained by molding the thermosetting resin composition into a sheet shape is at least 12 W/mK.

**INTERNATIONAL SEARCH REPORT**

International application No.
**PCT/JP2023/006385**

**Box No. III Observations where unity of invention is lacking (Continuation of item 3 of first sheet)**

1. ☐ As all required additional search fees were timely paid by the applicant, this international search report covers all searchable claims.

2. ☑ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

**INTERNATIONAL SEARCH REPORT**
**Information on patent family members**

International application No.
**PCT/JP2023/006385**

| Patent document cited in search report | Publication date (day/month/year) | Patent family member(s) | Publication date (day/month/year) |
|---|---|---|---|
| JP 2017-82091 A | 18 May 2017 | (Family: none) | |
| JP 2009-24126 A | 05 February 2009 | (Family: none) | |
| JP 2015-196823 A | 09 November 2015 | (Family: none) | |
| WO 2021/085593 A1 | 06 May 2021 | US 2022/0251335 A1<br>paragraphs [0041], [0057]-[0060], [0177]-[0181]<br>EP 4053213 A1<br>CN 114641532 A<br>KR 10-2022-0092870 A<br>TW 202124505 A | |
| JP 2019-29269 A | 21 February 2019 | JP 2021-122008 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017036415 A
- WO 2019189746 A
- WO 2015119198 A
- JP 2006176658 A


### Non-patent literature cited in the description


- Ceramics. Ceramic Society of Japan, 2008, vol. 43